## Europäisches Patentamt

## European Patent Office

## Office européen des brevets

(11) Numéro de publication: **0 208 601**
**B1**

(12) **FASCICULE DE BREVET EUROPEEN**

(45) Date de publication du fascicule du brevet:
25.10.89

(51) Int. Cl.⁴: **G01N 24/08**

(21) Numéro de dépôt: 86401423.8

(22) Date de dépôt: 27.06.86

(54) Procédé d'imagerie par résonance magnétique nucléaire.

(30) Priorité: 27.06.85 FR 8509824
13.08.85 FR 8512352
29.01.86 US 823522

(43) Date de publication de la demande:
14.01.87 Bulletin 87/3

(45) Mention de la délivrance du brevet:
25.10.89 Bulletin 89/43

(84) Etats contractants désignés:
DE FR GB IT NL

(73) Titulaire: GENERAL ELECTRIC CGR S.A., 100, rue
Camille-Desmoulins, F-92130 Issy les Moulineaux(FR)

(72) Inventeur: Breton, Eric c/o Thomson CSF SCPI,
19, avenue de Messine, F-75008 Paris(FR)
Inventeur: Le Bihan, Denis c/o Thomson CSF SCPI,
19, avenue de Messine, F-75008 Paris(FR)
Inventeur: Le Roux, Patrick c/o Thomson CSF SCPI,
19, avenue de Messine, F-75008 Paris(FR)

(74) Mandataire: Ballot, Paul Denis Jacques et al, Cabinet
Ballot-Schmit 84, avenue Kléber, F-75116 Paris(FR)

(56) Documents cités:
EP-A- 0 142 343

INVESTIGATIVE RADIOLOGY,
vol. 19, no. 6, novembre/décembre 1984, pages 484-
498, US; G.E. WESBEY et al.: "Translational molecular
self-diffusion in magnetic resonance imaging"
PHYSICS IN MEDICINE & BIOLOGY,
vol. 30, no. 4, avril 1985, pages 345-349, The Institute of
Physics, New York, US; D.G. TAYLOR et al.: "The
spatial mapping of translational diffusion coefficients
by the NMR imaging technique"
E. FUKUSHIMA et al.: "Experimental pulse NMR, a nuts
and bolts
approach", 1981, pages 197-210, Addison-Wesley

(56) Documents cités: (suite)
Publishing Co. Inc., Reading, Massachusetts, US;
JOURNAL OF PHYSICS E: SCIENTIFIC INSTRUMENTS,
vol. 11, 1978, pages 281-291, The Institute of Physics,
New York, US; J.R. SINGER: "NMR diffusion and flow
measurements and an introduction to spin phase
graphing"
THE JOURNAL OF CHEMICAL PHYSICS,
vol. 60, no. 8, 15 avril 1974, pages 2966-2979, American
Institute of Physics, New York, US; R. KAISER et al.:
"Diffusion and field-gradient effects in NMR Fourier
spectroscopy"
RADIOLOGY,
vol. 154, no. 2, février 1985, pages 433-441, RSNA,
Easton, US; P.R. MORAN et al.: "Verification and
evaluation of internal flow and motion"

## Description

La présente invention a pour objet un procédé d'imagerie par résonance magnétique nucléaire. L'utilisation de ce procédé est particulièrement envisagée dans le domaine médical pour représenter des coupes d'organes du corps humain.

L'imagerie par résonance magnétique nucléaire se développe principalement comme moyen de diagnostic médical. Elle permet la visualisation des structures internes tissulaires avec un contraste et une résolution jamais atteints simultanément par les autres procédés d'imagerie. Pour obtenir une image par résonance magnétique nucléaire d'une coupe d'organe avec différenciation des caractéristiques tissulaires de cet organe, on utilise la propriété qu'ont certains noyaux atomiques, comme les protons, d'orienter leur moment magnétique en acquérant de l'énergie lorsqu'ils sont placés dans un champ magnétique principal constant $B_0$. Une zone particulière d'un objet contenant des noyaux présente alors un moment magnétique global que l'on peut faire basculer selon une orientation donnée, perpendiculaire ou parallèle au champ $B_0$, en induisant une résonance par émission d'un champ radiofréquence perpendiculaire au champ principal.

Tous les noyaux possédant alors un moment magnétique, tournant à une vitesse de précession dite de Larmor, tendent à retrouver l'orientation initiale parallèle à $B_0$ en émettant un signal radio fréquence à la fréquence de résonance caractéristique de $B_0$ et du noyau. Ce signal peut être capté par une antenne de réception. La durée de retour à l'équilibre du moment magnétique global d'une région considérée et la décroissance du signal dépendent de deux facteurs importants : l'interaction spin-réseau et l'interaction spinspin du noyau avec la matière environnante. Ces deux facteurs conduisent à la définition de deux temps de relaxation dits respectivement $T_1$ et $T_2$. Une région considérée d'un objet émet donc un signal dont l'intensité dépend de $T_1$, de $T_2$, de la densité protonique de la région, et du temps qui s'est écoulé depuis l'excitation radiofréquence.

Pour localiser une région de l'organe il est nécessaire de repérer la nature de son émission en fonction de conditions locales de champ magnétique. Ces conditions locales sont imposées de façon à ce que la fréquence et la phase d'émission soient bien caractéristiques de la localisation dans l'espace de cette région de l'organe. Pour cela on superpose au champ principal $B_0$ des gradients de champs magnétiques pulsés. Ces gradients sont orientés selon des directions X, Y, Z pour définir à tous moments les éléments de volume qui résonnent à des fréquences connues. Pour l'acquisition d'une image entière les conditions locales sont imposées en des séquences programmées. Celles-ci sont mises en mémoire dans un ordinateur pilote. Ces séquences définissent les instants d'application des gradients, les instants d'excitation des noyaux par les impulsions du champ radiofréquence, ainsi que les instants de lecture ou d'acquisition des données de l'image.

Un autre facteur intervient pour modifier l'intensité du signal capté lorsque les noyaux retournent à leur orientation d'équilibre. Cet autre facteur dépend de la diffusion moléculaire du milieu. La diffusion moléculaire concerne les déplacements que subissent les molécules d'un milieu en fonction du temps. L'inhomogénéité du champ magnétique dans lequel se trouve ces molécules a alors pour conséquence que la fréquence de résonance magnétique de ces molécules évolue. En effet, cette fréquence est liée par le rapport gyromagnétique de ces molécules à l'intensité de ce champ. Aussi, au cours d'une expérimentation de résonance magnétique, en particulier une expérimentation avec une séquence d'échos de spin, le signal capté est inférieur à l'intensité attendue. En effet, la fréquentation par les molécules de régions de l'espace où les champs magnétiques sont différents a eu pour conséquence de modifier les phases relatives des contributions apportées par chacune de ces molécules au signal de résonance magnétique global capté. Comme les déplacements des molécules sont dans tous les sens, la dispersion de phase qui en résulte a pour effet que certaines contributions viennent mutuellement s'opposer. Le signal capté est alors moins fort. Cette perte de sensibilité mesure en quelque sorte la caractéristique de diffusion d'un milieu : un milieu fortement diffusant voit l'intensité de son signal de résonance magnétique décroître très rapidement avec le temps d'écho utilisé.

Il existe dans les organes humains des tissus pathologiques par exemple les angiomes et les tumeurs, qui présentent des signaux de résonance magnétique nucléaire classiques souvent identiques. Autrement dit des images de ces organes mettant en exergue les temps de relaxation $T_1$ ou $T_2$ ne permettent pas de discriminer ces conformations. Il en résulte que l'examen de l'image classique ne permet pas de prendre une décision thérapeutique. La présente invention a alors pour but de proposer des images où le paramètre mis en exergue est justement la caractéristique de diffusion moléculaire dans les tissus étudiés afin d'améliorer leur différenciation.

On connaît par le livre Biomedical Magnetic Résonance, édité par Radiology Research and Education Foundation (San Francisco) en 1984, un article dû à Messieurs WESBEY George et al, et intitulé "Translational Molecular Self-Diffusion in Magnetic Resonance Imaging : Effects and Applications". Cet article suggère de mesurer la constante de diffusion des régions d'un milieu en comparant l'effet relatif de la diffusion sur le milieu étudié et sur un corps étalon lors de séquences d'excitations magnétiques différentes. Dans la description qu'il donne de cette technique, il apparaît un inconvénient. En effet, ces séquences sont obtenues en incrémentant l'intensité d'un gradient de sélection de coupe, ce qui modifie l'épaisseur de la coupe étudiée. Cette méthode ne s'applique alors qu'à des objets plus fins que l'épaisseur de coupe la plus fine obtenue par les séquences utilisées. Elle n'est donc pas applicable chez l'homme. De plus, la sensibilité de cette méthode à la diffusion étant relativement faible (temps d'écho faibles, gradients inéfficacement placés dans la séquence), les auteurs utilisent plusieurs acquisitions pour atteindre une précision raisonnable sur la mesure. D'autre part, le recours à un même étalon est indispensable pour servir de référence aux mesures.

La présente invention permet d'établir une image de diffusion en évitant ces inconvénients. En particulier, les images sont à coupe d'épaisseur constante, ce qui rend les acquisitions sur l'homme réalisables, même avec un procédé multicoupe. La sensibilité à la diffusion est bonne : elle est due à l'utilisation de temps d'écho assez long et à des gradients efficaces par leur intensité et leur position. De plus, la détermination exacte des coefficients de diffusion est obtenue sans substance étalon. Dans l'invention, l'effet absolu de la diffusion a pu être calculé à partir des paramètres d'acquisition.

L'invention a pour objet un procédé d'imagerie par résonance magnétique nucléaire caractérisé en ce qu'il comporte les étapes suivantes pour donner une image de la diffusion moléculaire d'un corps étudié :
- on place le corps dans un champ magnétique constant $B_0$ ;
- on soumet le corps ainsi placé à une première pluralité de premières séquences d'excitations à écho de spin en présence de premières séquences de gradients de champ ; ces premières séquences à écho de spin comportant un nombre entier N supérieur ou égal à 1 d'excitations où les moments magnétiques des noyaux du corps sont basculés de 180° après une excitation où ces moments ont été basculés de 90° pour faire ainsi des séquences à N échos peu diffusantes ;
- on relève les signaux de résonance magnétique en fin de ces premières séquences et on calcule une première image correspondant à l'écho N de ces signaux en attribuant à chaque point de l'image une valeur correspondant au signal de résonance magnétique du point qui lui correspond dans le corps ;
- on soumet le corps ainsi placé à une deuxième pluralité de deuxièmes séquences d'excitations à échos de spin en présence de deuxièmes séquences de gradients de champ ; ces deuxièmes séquences à échos de spin comportant une excitation à 180° après une excitation à 90° pour faire des séquences à un écho diffusantes, la durée d'écho des deuxièmes séquences d'excitations étant égale à la durée totale d'écho des premières séquences d'excitations ;
- on relève les signaux de résonance magnétique en fin de ces deuxièmes séquences d'excitations et on calcule une deuxième image correspondant aux échos de ces signaux en attribuant à chaque point de l'image une valeur correspondant au signal de résonance magnétique du point qui lui correspond dans le corps ;
- on compare point à point les valeurs attribuées pour la première image aux valeurs attribuées pour la deuxième image, pour élaborer une troisième image représentative de la diffusion moléculaire en chaque point du corps

L'invention sera mieux comprise à la lecture de la description qui suit et à l'examen des figures qui l'accompagnent. Sur ces figures les mêmes repères désignent les mêmes éléments. Elles représentent :

- figure 1 un dispositif apte à la mise en oeuvre du procédé d'imagerie de l'invention ;
- figure 2a des diagrammes temporels de séquences d'excitations et de gradients de champ appliqués au corps pour élaborer les premières et deuxièmes images ;
- figures 2b et 2c des diagrammes temporels de gradients dits homologues compensés, utilisés pour augmenter la sensibilité à l'effet de la diffusion ;
- figures 3a et 3b les allures des signaux relevés respectivement à l'issue des premières et deuxièmes séquences d'excitations ;
- figure 4 une machine pour la mise en oeuvre dans l'invention d'un procédé de modulation selon un perfectionnement ;
- figure 5 des diagrammes temporels de signaux radiofréquence d'excitation, de signaux de champ magnétique perturbateur, et de signaux relevés dans une mesure particulière comportant une imagerie de type 2DFT d'une coupe d'un corps sous examen ;
- figures 6a et 6b des diagrammes temporels de déphasages résultant, après application de séquences de champs magnétiques perturbateurs, entre les contributions émises par des particules fixes et des particules en mouvement ;
figure 7 une représentation schématique de la réponse d'une partie d'un milieu dont les particules sont en déplacement selon que ce déplacement est parallèle ou perpendiculaire à un plan de coupe imagé.

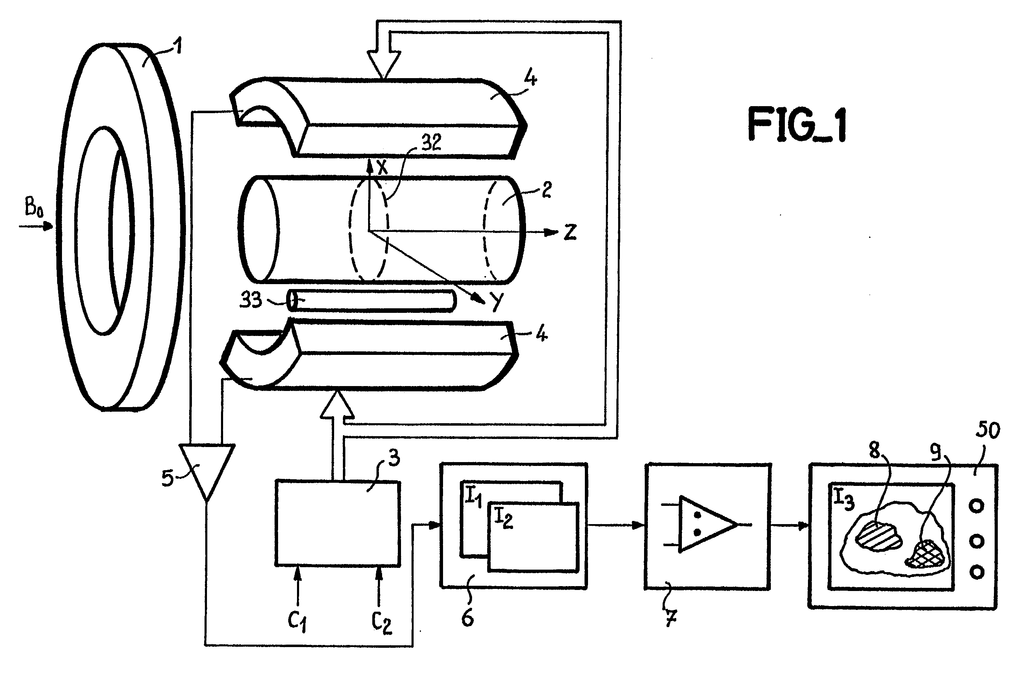

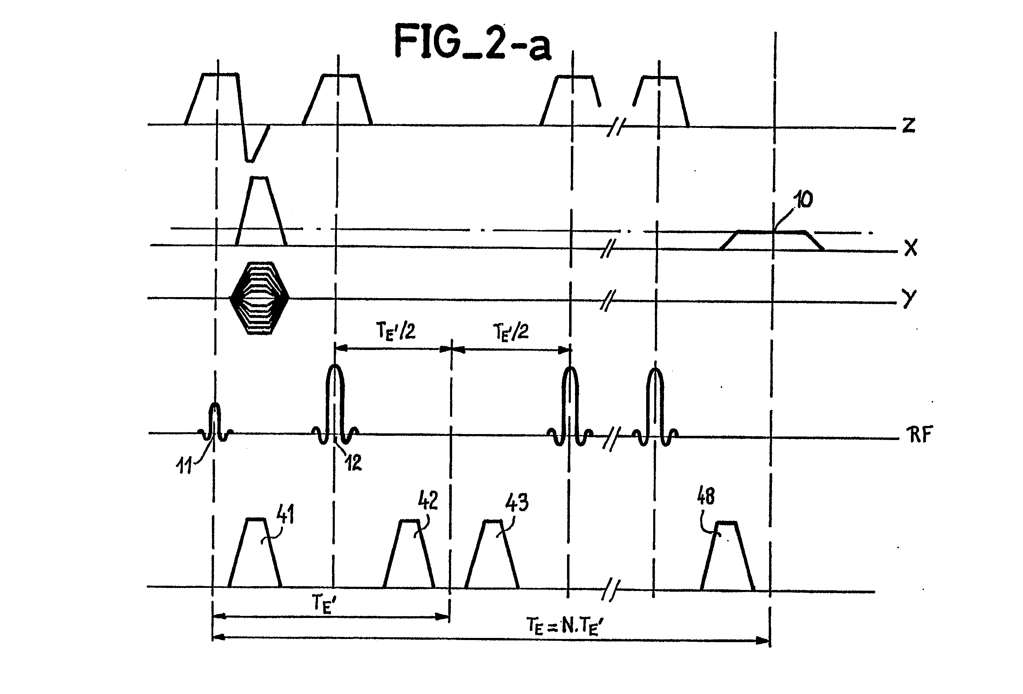

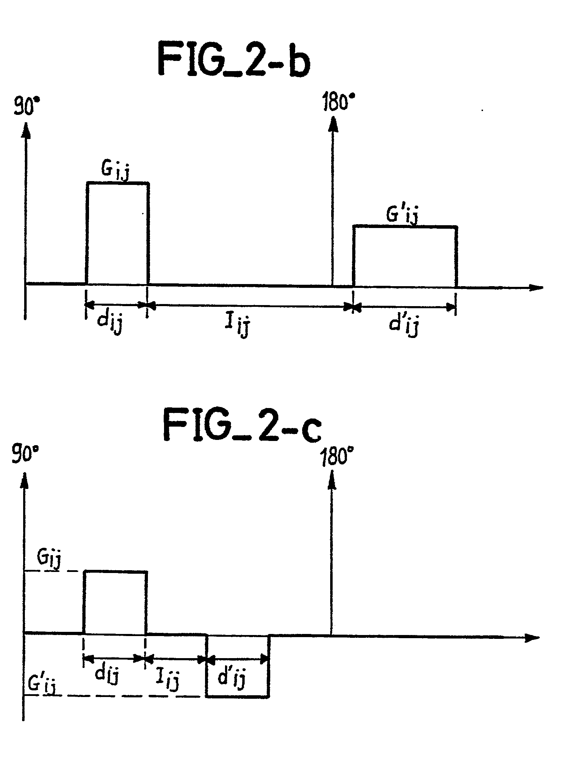

La figure 1 représente un dispositif pour la mise en oeuvre du procédé d'imagerie selon l'invention. Ce dispositif comporte des moyens symbolisés par une bobine 1 pour soumettre un corps 2 à un champ magnétique important et constant $B_0$. Ce dispositif comporte encore des moyens générateur 3 et bobines 4 pour soumettre le corps ainsi placé à des séquences d'écho de spin à un ou plusieurs échos en présence de séquences de gradients de champ (figure 2 a). Les bobines 4 représentent les bobines radiofréquence et les bobines de gradient de champ. Il comporte encore des moyens de réception 5 reliés aux bobines 4 pour recevoir le signal de résonance magnétique, et des moyens 6 pour calculer et mémoriser une première image $I_1$ et une deuxième image $I_2$ relatives à deux séries d'expérimentations imposées par des commandes symbolisées $C_1$ et $C_2$ des moyens générateurs 3. Dans des moyens de comparaison 7 on compare point à point les images $I_1$, $I_2$, en calculant le logarithme du rapport des valeurs représentatives des signaux de résonance magnétique. Les moyens 7 élaborent alors une troisième image $I_3$ dans laquelle deux régions 8 et 9 du milieu à l'endroit de la coupe imagée présentent des réponses en valeur de diffusion différentes alors qu'elles auraient présenté des réponses identiques en image de résonance magnétique classique. Ces images peuvent être visualisées sur un dispositif de visualisation 50.

Le processus de calcul des images $I_1$ ou $I_2$ est classique. Dans un exemple la méthode d'imagerie employée par les moyens 6 est une méthode dite 2DFT. Cette méthode d'imagerie permet actuellement d'obtenir la meilleure qualité d'image. Dans cette méthode d'imagerie seul un plan de coupe est excité à la fois, par le moyen d'excitations radiofréquence (90° ou 180°) de forme particulière, en présence d'un gradient dit de sélection. Dans la figure 1, le gradient de sélection peut être orienté selon l'axe Z pour sélectionner une coupe transverse, c'est-à-dire selon un plan X, Y. Le principe de l'imagerie 2DFT est de coder en phase les différents signaux acquis. Ceci est obtenu par une impulsion, d'intensité variable, d'un gradient dit "déphaseur", d'axe perpendiculaire à un gradient de lecture dont la direction est constante. Par exemple, pour une coupe transverse, le gradient de lecture pourra être de gradient X et le gradient de déphasage pourra être le gradient Y. Puis par une double transformée de Fourier spatiale, l'image est construite, d'où le nom de la méthode. On pourra trouver une description de ce mode d'imagerie dans le livre : "Imagerie par résonance magnétique" de M. LE BIHAN publié par les Editions MASSON, Paris, MARS 1985. Une amélioration de cette méthode peut d'ailleurs permettre d'obtenir simultanément des images de plusieurs coupes parallèles.

La figure 2 a représenté typiquement des séquences de gradient de champ selon les trois axes Z, X, Y ainsi que les instants d'application des excitations radiofréquence tendant à faire basculer les spins des noyaux de 90° pour les petites excitations et de 180° pour les grandes excitations. Pour imager une coupe d'un corps il y a lieu de réaliser des séquences d'excitations à écho de spin en présence de séquences de gradient de champ, en un nombre aussi important de fois que la résolution de l'image attendue doit être plus précise. A chaque séquence d'excitations le gradient déphaseur, Y, varie par pas successifs partant d'une certaine valeur jusqu'à la même valeur mais de signe opposé. Cette valeur dépend de la forme et de la durée du gradient 10 de lecture. Ce gradient déphaseur permet de faire tourner chaque spin d'une phase variable, dépendante de son ordonnée suivant l'axe Y et de la valeur de ce gradient. Pour chaque image $I_1$ et $I_2$ le gradient Y peut prendre successivement le même nombre de valeurs : d'une manière préférée la définition des deux images sera la même.

Ce qui diffère dans l'invention entre la première image $I_1$ et la deuxième image $I_2$ est le nombre des séquences d'excitations radiofréquence à écho de spin et/ou l'intensité et la forme des séquences de gradient. Le calcul effectué par les moyens 7 de comparaison est lié à la manière dont les images ont été acquises et au contenu d'information que ces images renferment. Dans les premières séquences d'excitations à échos de spin, N excitations 12 dites à 180° succèdent à une seule excitation 11 à 90°. Le nombre N est plus grand ou égal à un. Dans les deuxièmes séquences d'excitations à écho de spin il n'y a qu'une seule impulsion à 180° qui suit l'excitation à 90°. Par ailleurs la durée du temps d'écho $T_E$ de la deuxième séquence d'excitations à échos de spin est égale à N fois la durée du temps d'écho $T_{E'}$ de la première séquence d'excitations à échos de spin. Pour des raisons de simplicité dans les premières séquences à échos de spin, les temps d'écho successifs sont égaux entre eux. Il est plus facile en effet de diviser une durée donnée $T_E$ en un nombre entier de durées élementaires $T_{E'}$ égales. Mais si les temps d'écho successifs $T_{E'}$ des premières séquences à écho de spin ne sont pas égaux entre eux, l'invention peut quand même fonctionner : il importe que la durée entre l'impulsion 90° 11 et la date de mesure 10 dans l'un et l'autre cas soit la même.

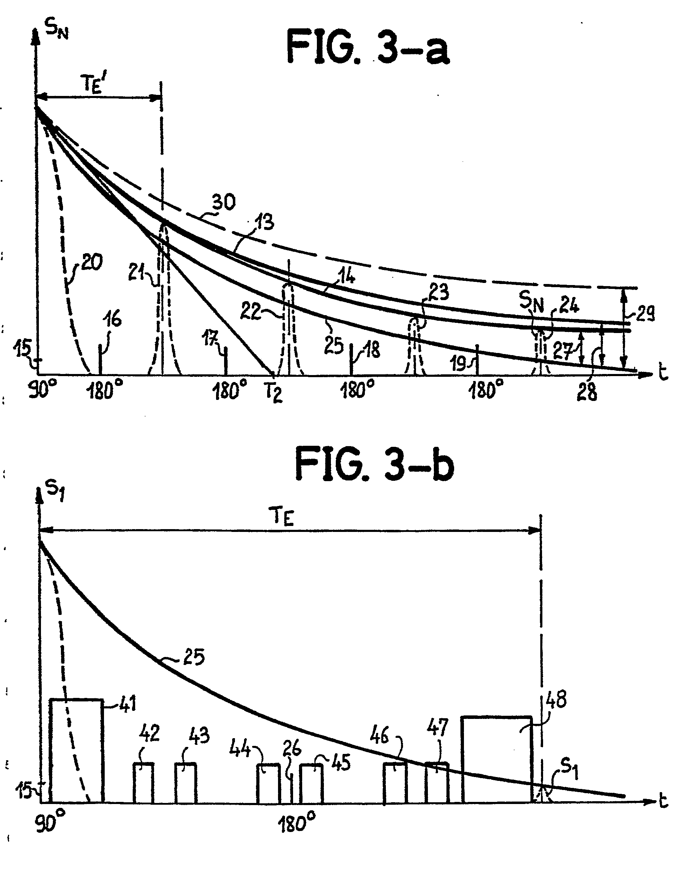

Dans l'exemple qui apparaît sur la figure 3a la première séquence à échos de spin comporte quatre durées d'écho égales $T_{E'}$ au milieu desquelles chaque fois une impulsion de 180° prend place. Sur la figure 3b, pendant une même durée $T_E$, une seule impulsion à 180° 26 vient s'interposer. Dans un exemple la durée $T_E$ vaut 112 millisecondes, et la durée $T_{E'}$ vaut 28 millisecondes. Dans cet exemple le temps de répétition TR, qui est le temps qui sépare pour l'une ou l'autre image, chaque séquence à écho de spin au cours de laquelle le gradient Y prend une valeur différente, vaut une seconde. Cette valeur de 112 millisecondes est choisie suffisamment grande pour obtenir une bonne sensibilité sur l'effet de la diffusion et un rapport signal sur bruit raisonnable. On sait par des commandes $C_1$ et $C_2$ provoquer de telles séquences d'excitations-mesures. Ces commandes dépendent des machines utilisées.

Dans l'invention, on a trouvé que la contribution d'une partie du milieu au signal de résonance magnétique relevé au bout du temps d'écho $N.T_{E'}$ dans une première séquence d'excitations a la forme suivante :

$$S_N(NT_{E'}) \approx f(\rho, T_1, T_2, NT_{E''}, TR) . \exp\left(-\gamma^2 D \sum_{j=1}^{N} \sum_{i=1}^{m} G_{ij} \, d_{ij} \left(\frac{d_{ij} + d'_{ij}}{3} + I_{ij}\right)\right)$$

$$\text{où } f = \rho \, e^{-\frac{NT_{E'}}{T_2}} . \left(1 - e^{-\left(\frac{TR - NT_{E'}}{T_1}\right)}\right)$$

Dans ces expressions $\rho$ est la densité de protons à l'endroit considéré, $\gamma$ est le rapport gyromagnétique des molécules du milieu dans cet endroit, et $G_{ij}$ et $d_{ij}$ correspondent à une paire de gradients homologues compensés tels que présentés sur les figures 2b ou 2c. Une paire de gradients homologues compensés correspond à une paire de gradients d'intensité $G_{ij}$ et $G'_{ij}$ et de durées $d_{ij}$ et $d'_{ij}$ tels que $G_{ij}.d_{ij} = G'_{ij}.d'_{ij}$. Si les gradients sont placés de part et d'autre d'une impulsion d'excitation radiofréquence à 180°; les intensités $G_{ij}$ et $G'_{ij}$ sont de même signe. Si les gradients sont placés d'un même côté, elles sont de signe contraire. Les sommes portent sur le nombre $\underline{m}$ de paires homologues compensées d'impulsions de gradient et sur le nombre N d'échos de spin. Par exemple, sur la figure 3b, il y a quatre paires homologues compensées d'impulsions de gradient auxquelles pour calculer $\underline{m}$ il faut rajouter les paires de gradient homologues compensés correspondant à une séquence d'imagerie normale. Pour la deuxième séquence d'excitations $N.T_{E'}$ est remplacé par $T_E$, et N est remplacé par 1. Les paramètres $G_{ij}$, $d_{ij}$, et $\underline{m}$ y sont alors différents. Dans ce cas, le signal est dit $S_1(T_E)$. Les contributions d'un point du milieu sont apportées dans le signal de résonance magnétique en commun avec les contributions des autres points de la tranche examinée dans le milieu. La méthode d'imagerie 2DFT permet en définitive d'affecter à chaque point des images $I_1$ ou $I_2$ une valeur qui est représentative de ces contributions.

La figure 3a représente par la courbe enveloppe 13 le signal théorique résultant de l'existence d'un temps de relaxation $T_2$ quand tous les autres effets parasites, y compris la diffusion, peuvent être négligés. La courbe 14 montre ce qu'il advient de cette courbe théorique quand on la mesure avec des séquences dites peu diffusantes : c'est-à-dire quand l'effet de la diffusion se fait peu sentir. Cet effet se fait peu sentir si le nombre N est suffisamment grand pour un temps $T_E$ (= $NT_{E'}$) donné : par exemple ici il vaut 4. En effet dans la formule de la contribution, plus N est grand plus les coefficients $d_{ij}$ et $I_{ij}$ sont petits et plus l'effet de la diffusion est faible. Les excitations radiofréquence notées 15 à 19 de la figure 3a comportent une excitation tendant à faire basculer à 90° les noyaux du corps (excitation 15) et quatre excitations successives tendant à faire basculer de 180° ces noyaux (16 à 19). Le signal en pointillé 20 est le signal de résonance magnétique nucléaire après la première excitation de 90°. Les sommets 21 à 24 des pics de ce signal, mesuré après des périodes de temps d'échos $T_{E'}$ successives, suivent la courbe 14. Le signal $S_N$ de la formule précédente correspond à l'amplitude du pic 24.

La figure 3a présente encore l'enveloppe 25 de ces pics lorsque le corps est soumis à des séquences diffusantes. La courbe 25 est par ailleurs reportée sur la figure 3b. Dans une séquence diffusante une seule excitation à 180° 26 suit l'impulsion à 90° 15. Le signal mesuré au bout du temps d'écho $T_E$ est coté $S_1$. La valeur de ce signal est donnée par une formule identique à la précédente : la seule différence vient du fait que dans ce cas N vaut 1. On comprend à l'examen de ces deux figures que l'on va pouvoir en comparant une image $I_1$, relative à des pics qui suivent l'enveloppe 14, à une image $I_2$, relative à des pics qui suivent une courbe 25, représenter une image $I_3$ relative à l'écart 27 entre ces deux courbes. Dans la mesure où la séquence peu diffusante peut être de moins en moins diffusante la courbe 14 se rapproche de la courbe 13. Cela permet de représenter une image où l'effet 28 de la diffusion seule peut être encore mieux mis en évidence. Il est utile de noter que la troisième image obtenue avec le procédé de l'invention diffère de l'enseignement donné dans le document précité. Avec cet enseignement, le signal est proportionnel à un écart 29 entre les effets de la diffusion dans le corps étudié et dans un corps étalon dont la réponse en diffusion serait inscrite dans la courbe en tirets 30.

Dans l'invention, on effectue le rapport des signaux $S_N$ et $S_1$ et on prend le logarithme de ce rapport. On peut ainsi élaborer un signal représentatif (point à point dans l'image) et correspondant à la formule suivante :

$$Log\left(\frac{S_N}{S_1}\right) = D\,(b_{1m} - b_{Nm}) = KD$$

$$\text{avec } b_{km} = \gamma^2 \cdot \sum_{j=1}^{j=k} \sum_{i=1}^{i=m} \left(G_{ij}^2 \cdot d_{ij}^2 \left(\frac{d_{ij} + d''_{ij}}{3} + I_{ij}\right)\right)$$

Cette formule montre que le traitement ainsi effectué sur $S_N$ et $S_1$ rend compte, à un facteur K près, de la mesure de la constante de diffusion à l'endroit considéré dans l'image. Mais ce rapport ne donne le résultat ci-dessus indiqué que dans la mesure où, d'une part, les instants temps de prélèvement des signaux, $T_E$ et $N.T_{E'}$, sont égaux entre eux et où, d'autre part, le temps de répétition TR est le même pour les séquences à N échos et pour celles à un écho. La fonction f prend alors la même valeur pour les deux séquences et elle disparaît dans le calcul de l'image $I_3$ où n'apparaît plus que l'effet de la diffusion.

Pour que l'effet de la diffusion, courbe 25, se fasse bien sentir il est intéressant d'avoir un temps d'écho $T_E$ dans les deuxièmes séquences qui soit suffisamment long et/ou d'utiliser des gradients plus forts, plus longs, que dans une séquence classique. Notamment des gradients 41 à 48 supplémentaires, écartés au maximum des impulsions d'excitation radiofréquence à 180°, peuvent être utilisés en dehors des périodes pendant lesquelles les excitations radiofréquence sont appliquées ou reçues. Par contre pour que l'effet de la diffusion, dans la séquence non diffusante, soit minimisé, on peut prendre un nombre N suffisamment important : N = 4 semble suffisant.

Un gradient supplémentaire est montré sur la figure 2a en dessous du graphe des excitations radiofréquence. Il peut être appliqué sur l'un quelconque des axes X, Y ou Z. On peut par exemple l'appliquer sur l'axe de codage de phase ou de sélection. Appliqué sur l'axe de la sélection, il n'interfère pas dans l'épaisseur de la tranche sélectionnée dans le corps dans la mesure où son application, supplémentaire, est faite en dehors des temps d'application des excitations radiofréquence pendant lesquelles le gradient de sélection est lui présent. En effet si le gradient de sélection reçoit pendant les excitations de sélection 90° et de retournement 180° un supplément de valeur, l'inhomogénéité qu'il provoque sera plus forte. Pour une même bande passante donnée de l'excitation, l'épaisseur de la tranche excitée dans le corps 2 sera plus fine. Le signal que restituera cette tranche plus fine sera plus faible. Si on veut qu'il soit aussi fort, il faut alors augmenter la bande passante des excitations et ce procédé nuit alors à la simplicité de la méthode. De manière préférée, le gradient supplémentaire sera appliqué en supplément du gradient de lecture. D'une manière préférée, toutes choses étant égales par ailleurs, on s'arrangera pour que les gradients ajoutés le soient en des périodes les plus éloignées possible de celles où les excitations de basculement, les excitations 12, sont appliquées.

La figure 3b donne une idée des durées pendant lesquelles on peut appliquer d'une manière préférée les suppléments 41 à 48 de gradient de champ. Ceux-ci sont appliqués en dehors des dates auxquelles on relève les pics du signal de résonance magnétique nucléaire. Dans la représentation les gradients 41 et 48 sont dyssimétriques. Mais comme ils sont homologues compensés par rapport à l'impulsion de basculement 26 leurs intégrales par rapport au temps sont égales. Les grandes impulsions 41 et 48 peuvent être utilisées seules. Elles sont le plus éloignées possible de l'excitation 26.

Le choix de l'axe sur lequel les impulsions supplémentaires des gradients sont appliquées peut ne pas être indifférent. Si on considère que la diffusion moléculaire est un phénomène isotrope c'est effectivement le cas. Par contre si on considère que la diffusion moléculaire peut, dans certains cas, être anisotrope, il peut être intéressant de choisir l'axe sur lequel on va favoriser l'effet de diffusion. En particulier certains tissus du corps humain ont par leur disposition dans le corps une orientation privilégiée. Cette orientation privilégiée résulte d'une forme privilégiée des cellules qui les constituent. Ces cellules qui n'ont aucune raison d'être globalement symétriques sur trois axes présentent alors des coefficients de diffusion moléculaires différents selon chacun de ces trois axes. En comparant des images de diffusion moléculaire obtenues selon le procédé de l'invention avec des suppléments de gradients de champ appliqués selon un axe puis selon un autre axe il peut être ultérieurement possible de déterminer à quelle nature de tissu on a à faire.

La mesure de la diffusion donnée dans la troisième image est une mesure quantitative à partir du calcul des coefficients $b_{km}$ (k valant 1 ou N selon les séquences) et donc du facteur K. Toutefois, les imperfections inhérentes aux systèmes d'imagerie peuvent entraîner une atténuation globale des signaux $S_N$ ou $S_1$ en chaque point de l'image, par exemple épaisseur de coupe légèrement différente, mauvais rephasage de la sélection de coupe d'une des deux images, ... Cette atténuation globale peut être calibrée à l'aide d'une substance étalon 33 disposée le long du corps étudié de façon à ce qu'elle apparaisse sur les bords du champ de l'image. Si $Se_N$ et $Se_1$ sont les signaux de résonance magnétique dans le corps étalon, correspondant aux signaux $S_N$ et $S_1$ dans le corps étudié, respectivement à la fin des séquences peu diffusantes et diffusantes, on peut écrire que le coefficient de diffusion molléculaire d'un point de la coupe vaut :

$$D = \frac{1}{K} \left( \log \frac{S_N}{S_1} + \log \frac{Se_N}{Se_1} \right) - De$$

où De est le coefficient de diffusion moléculaire connu du corps étalon. Dans ces conditions la calibration est obtenue simplement.

En fait dans un tissu vivant deux phénomènes de déplacement se produisent. Un premier phénomène est dû à la diffusion moléculaire comme évoquée jusqu'ici. Un deuxième phénomène est dû aux micro-circulations dans les tissus. Ces micro-circulations relèvent essentiellement de la vascularisation sanguine. Ces micro-circulations viennent perturber l'image de diffusion moléculaire. Aussi, dans une variante, l'invention est mise en oeuvre en modulant l'effet de la vitesse des parties mobiles (le sang) du tissu selon un procédé de modulation dont la description est annexée ci-après. Le procédé de modulation décrit ci-après permet de moduler l'effet (sur le signal de résonance) de ces micro-circulations. Dans ce procédé de modulation on sait, par adjonction de gradients dits bipolaires compensateurs, faire en sorte que dans l'image les molécules du sang soient prises en compte comme si elles étaient fixes. Dans ces conditions le phénomène de diffusion apparaît seul. Ce procédé de modulation a été préalablement décrit dans une demande de brevet français déposée le 13 AOUT 1985 sous le N° 85 12352. Le contenu de cette demande préalable fait maintenant partie intégrante de la présente invention.

Pour le perfectionnement ainsi apporté, on peut expliquer que les micro-circulations (elles sont des déplacements lents) perturbent les séquences diffusantes à cause des gradients de sensibilisation suffisamment forts que ces séquences comportent. C'est donc d'une manière préférée les séquences diffusantes qui sont compensées. La question se pose de savoir comment cette compensation, recherchée par ce qu'elle neutralise l'effet indésirable des micro-circulations, ne neutralise pas en même temps l'effet de la diffusion. Les inventeurs de la présente invention pensent que cette non-neutralisation est dûe à une distribution temporellement incohérente des déplacements de diffusion moléculaires. Par contre les micro-circulations sont des déplacements cohérents puisque leurs vitesses sont quasiment constantes. Autrement dit, la réduction du signal de résonance mesurée au cours d'une séquence diffusante (par rapport à celui mesuré au cours d'une séquence non diffusante) est dûe maintenant uniquement à la diffusion et non plus aussi aux micro-circulations dont l'effet a été neutralisé.

Le perfectionnement a pour objet un procédé de modulation de l'effet de la vitesse des parties mobiles d'un corps dans une mesure de densité par résonance magnétique nucléaire (RMN) ainsi que la mise en oeuvre du procédé pour en déduire la vitesse des parties mobiles concernées. Ce perfectionnement trouve son application particulièrement dans le domaine médical où les corps examinés sont des corps humains et où les parties mobiles sont des cellules du sang circulant dans des veines ou des artères ou des organes mobiles tels que le muscle cardiaque. Dans cette application, il peut même plus particulièrement être mis en oeuvre avec un procédé d'imagerie pour donner une image représentative de la répartition des vitesses des parties mobiles dans une coupe du corps examiné.

Au cours d'une expérience de résonance, si le champ orientateur $B_0$ est parfaitement homogène, des particules mobiles dans une région considérée émettent en réponse un signal identique à celui des particules fixes de cette région. Par contre si le champ orientateur n'est pas homogène, ou plus généralement si pour diverses raisons (en particulier pour faire de l'imagerie) on applique pendant ou après l'excitation magnétique radiofréquence un champ magnétique perturbateur, présentant un gradient d'intensité, on peut montrer que les contributions apportées par les particules mobiles dans le signal global émis sont affectées d'une composante de phase dépendant justement de leur vitesse. Ceci peut se comprendre simplement : le signal de résonance émis vibre à une fréquence $f_0$ qui dépend de l'intensité du champ magnétique orientateur $B_0$ et du rapport gyromagnétique $\gamma$ caractéristique du milieu examiné. Toutes variations de l'intensité du champ $B_0$ provoquent donc une variation correspondante de la fréquence de résonance. En conséquence, une particule fixe soumise, après l'excitation radiofréquence, pendant un premier temps au champ $B_0$ résonne à une fréquence $f_0$, dans un deuxième temps, soumise à un champ plus fort $B_0 + \Delta B_0$, elle résonne à une fréquence plus élevée $f_0 + \Delta f_0$. Dans un troisième temps à nouveau soumise au champ $B_0$ elle vibre à nouveau à la fréquence $f_0$. Au cours du troisième temps le signal émis est alors déphasé par rapport à sa phase pendant le premier temps. Ce déphasage est proportionnel à l'amplitude de la perturbation $\Delta B_0$ et à la durée de cette perturbation. Si toutes les particules du milieu sont fixes ou, si la perturbation qui a atteint dans le temps tout le milieu n'a pas de gradient, il en résulte simplement que le signal global émis est seulement retardé.

Il en va différemment par contre pour les particules animées d'une certaine vitesse quand la perturbation présente un gradient. Celles-ci fréquentent au cours des trois périodes (du fait de leur vitesse de déplacement pendant ces périodes) des régions de l'espace où les champs orientateurs et perturbateurs sont différents. Ils sont différents respectivement du fait de l'existence d'inhomogénéités ou du fait de l'existence de gradients. En conséquence la contribution des particules mobiles dans le signal se trouve apportée avec une phase qui dépend non seulement de l'amplitude des perturbations rencontrées (comme pour les particules fixes) mais aussi de la variation d'amplitude de ces perturbations le long du parcours qu'elles ont emprunté. Cette variation qui constitue le gradient est géographiquement imposée.

En conséquence, le déphasage du signal des particules mobiles dépend alors de leur vitesse puisque elles fréquentent d'autant plus de régions de l'espace que leur vitesse est grande. Si les vitesses de déplacement, les inhomogénéités, ou les gradients de champ sont trop grands, les phases des différentes contributions peuvent en être à ce point affectées qu'elles finissent par s'opposer. Dans ce cas, ces contributions s'annulent mutuellement et le signal global résultant est moins fort. Dans la pratique cet effet est tel qu'il donne souvent l'illusion qu'il n'y a pas de matière dans un corps à l'endroit où circulent des particules mobiles.

Pour faire apparaître l'existence des particules mobiles et pour en mesurer les caractéristiques, la densité et éventuellement la vitesse de déplacement, on peut procéder selon une méthode décrite par E.L.HAHN en Février 1960 dans le Journal of GEOPHYSICAL RESEARCH, volume 65, n° 2, pages 776 et suivantes. L'auteur y suggère de soumettre le milieu étudié à une séquence d'un gradient particulier : à le coder. Le principe de ce codage consiste à appliquer après le basculement de l'impulsion radiofréquence, un gradient dit bipolaire selon l'axe d'une composante de vitesse que l'on veut reconnaître. Un gradient bipolaire est tel que son intégrale temporelle, du temps correspondant au début de l'impulsion radiofréquence au temps correspondant au début de la mesure, est nulle. Le moment magnétique de spin d'une particule immobile ne subit dans ce cas qu'un déphasage global nul. En effet le déphasage subit pendant l'application d'une première partie du gradient bipolaire est compensé par l'application de la deuxième partie de ce gradient bipolaire. Par contre une particule mobile, ayant une vitesse positive suivant l'axe du gradient, subit lors de la deuxième partie de l'impulsion un déphasage plus important en valeur absolue que pendant la première partie. Parce qu'elle fréquente pendant cette deuxième partie une région de l'espace où, du fait du gradient le champ magnétique perturbateur est plus fort. En comparant une mesure relevée avec un tel gradient bipolaire à une mesure relevée sans qu'il ait été appliqué, on peut en déduire la vitesse et le nombre des particules mobiles.

Quels que soient les buts poursuivis, mesure simple ou mesure avec image, et quelles que soient les procédures retenues, la sensibilité du phénomène de vitesse au champ magnétique perturbateur appliqué est telle, qu'en définitive, la mise en évidence des phénomènes de déplacement n'est possible que tant que les vitesses maximum sont inférieures à une limite. En particulier en imagerie, selon que la composante de vitesse à mettre en évidence est parallèle ou perpendiculaire au plan de la coupe imagée, la sensibilité des machines de RMN est actuellement de l'ordre de 1 radian/(cm/s) à 0,2 rd/(cm/s). Ceci signifie qu'une particule qui se déplace de 1 cm par seconde dans le plan de la coupe contribue au signal global émis avec un déphasage de 1 radian par rapport aux contributions émises par les particules fixes. Dans le corps humain une vitesse nominale de circulation du sang de 50 cm/s est couramment atteinte, voire même de plusieurs mètres par seconde dans le coeur. De plus la distribution des vitesses dans un vaisseau est étalée entre zéro, sur les bords du vaisseau, et la vitesse nominale au centre du vaisseau. Donc chaque particule d'un vaisseau contribue au signal avec un déphasage qui peut valoir de 0 à 50 radians ! Sachant que des contributions déphasées de $\pi$ radians s'opposent mutuellement, le signal résultant est nul : cela revient à prendre la valeur moyenne d'un signal sinusoidal sur plusieurs périodes. A titre d'exemple, Paul R. Moran dans un article de la revue Radiology du RSNA de 1985, 154, pages 433 à 441, fait état d'une mesure de vitesse moyenne égale à 0,6 cm par seconde et correspondant à un déphasage d'environ 90°. Au delà de cette limite, la sensibilité des machines est trop forte et les vitesses ne sont plus mesurables.

Le perfectionnement a pour objet de mettre en évidence l'effet de la vitesse des parties mobiles d'un corps en modifiant la sensibilité des machines d'une manière particulière. La modification de sensibilité, tout en ne modifiant d'aucune manière les signaux émis par les parties fixes, peut avoir pour effet d'annuler la part de déphasage dû à la vitesse. Les particules en mouvement contribuent alors au signal global comme si elles étaient fixes. Le procédé de modulation permet par ailleurs, plutôt que de tout annuler, de moduler l'effet de la vitesse. En faisant deux mesures, avec des caractéristiques de modulation différentes, et en comparant les deux mesures, on peut supprimer l'incidence des parties fixes pour ne laisser apparaître que celle des parties mobiles. Dans cette comparaison les parties mobiles apparaissent pondérées par les caractéristiques de modulation des deux expérimentations. Dans l'invention ces caractéristiques sont calculables et l'effet de la vitesse peut être quantifié.

Le principe énoncé dans le procédé de modulation est très général. Il n'est pas cantonné à une application, plus complète, d'imagerie. Il peut en particulier être mis en oeuvre avec les spectromètres de masse. Par ailleurs, il s'applique quelles que soient les procédures d'excitation radiofréquence retenues : procédures connues souvent sous leurs noms anglo-saxon de saturation recovery, inversion recovery, double saturation recovery, saturation recovery - inversion recovery, spin-echo, etc... De même l'invention, dans le cadre de l'imagerie, est applicable quelle que soit la procédure d'imagerie retenue : par exemple que celle-ci soit une méthode de retroprojection de type P.C. Lauterbur, une méthode par transformée de Fourier de type 3DFT ou 2DFT mise au point par A. Kumar et R.R. Ernst ou sa variante connue sous le nom de spin warp (c'est dans cette seconde méthode que le perfectionnement sera décrit ), une méthode d'imagerie des volumes sensibles mise au point par W.F. Hinshaw, ou encore une méthode d'acquisition rapide mise au point par P. Mansfield et plus connue sous le nom de "Echo-planar", etc... En effet, dans toutes les situations impliquées par ces procédures, la modulation est possible puisqu'elle consiste à modifier les champs magnétiques perturbateurs (les gradients de champ) en leur adjoignant des champs magnétiques compensateurs d'allure semblable, et dont les caractéristiques de forme, de durée, et d'amplitude dépendent de ces champs magnétique perturbateurs.

Le perfectionnement a pour objet un procédé de modulation de l'effet de la vitesse des parties mobiles d'un corps dans une mesure de densité par résonance magnétique nucléaire, mesure pour laquelle

- on soumet le corps à un champ magnétique orientateur et constant pour orienter dans une direction unique des moments magnétiques de spin du corps,
- on fait subir à ce corps une excitation magnétique radio fréquence en présence et/ou suivie de l'application d'une séquence d'un champ magnétique perturbateur,
- et on relève un signal de résonance magnétique émis en réponse par le corps,

ce procédé étant caractérisé en ce qu'on module l'effet de la vitesse des parties mobiles du corps créé par la séquence du champ perturbateur, par l'application, avant le relevé, d'une séquence d'un champ magnétique compensateur, dont l'intégrale calculée sur sa durée est nulle, et dont l'historique et la valeur sont fonction de l'historique et de la valeur du champ perturbateur.

Le perfectionnement concerne également une mise en oeuvre de ce procédé, caractérisée en ce qu'on le met une première fois en oeuvre pour compenser l'effet de la vitesse, et une autre fois en oeuvre en modifiant une ou plusieurs des caractéristiques du champ magnétique compensateur et en ce qu'on compare les mesures obtenues dans les deux mises en oeuvre pour en déduire la vitesse des parties mobiles concernées.

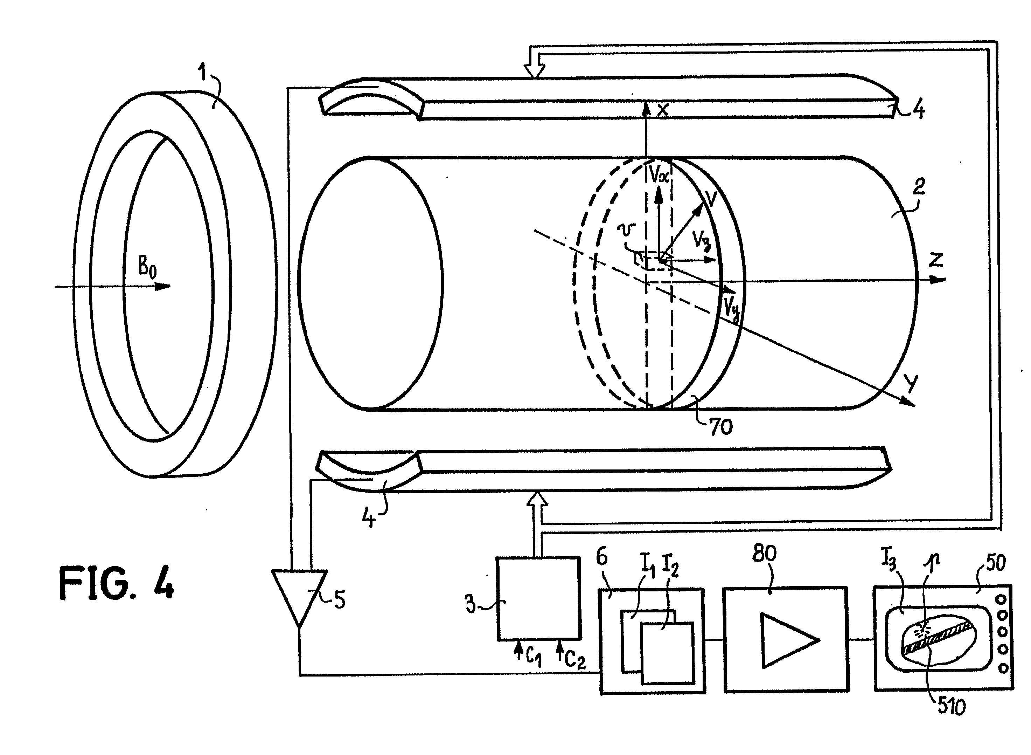

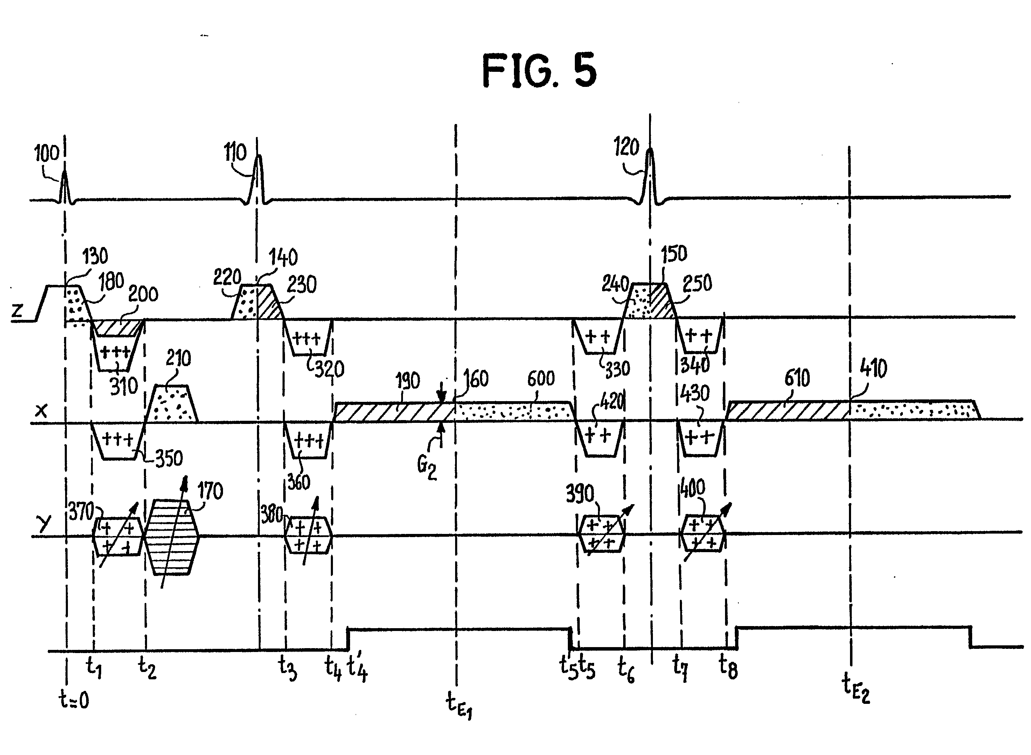

La figure 4 représente une machine utilisable pour mettre en oeuvre le procédé du perfectionnement. Elle comporte des moyens symbolisés par une bobine 1 pour soumettre un corps 2 à un champ magnétique important et constant $B_0$. Le champ $B_0$ est le champ orientateur. La machine comporte encore des moyens générateurs 3 et bobines 4, reliés aux moyens générateurs 3, pour soumettre le corps ainsi placé à des séquences d'excitation radiofréquence en présence de séquences de champ perturbateur : des gradients de champ orientés selon trois axes de référence de la machine X , Y ou Z (figure 5). Les bobines 4 représentent en même temps les bobines radiofréquence et les bobines de gradient de champ. La machine comporte encore des moyens de réception 5, reliés aux bobines 4, pour recevoir le signal de résonance magnétique. Dans une application d'imagerie, des moyens 6 peuvent permettre de calculer et de mémoriser une première image $I_1$ et une deuxième image $I_2$ d'une coupe 70 du corps 2. Les deux images sont relatives à deux séries d'expérimentation imposées par des commandes symbo lisées $C_1$ et $C_2$ des moyens générateurs 30. Dans des moyens de comparaison 80 on compare point à point les images $I_1$ , $I_2$, et on élabore une troisième image $I_3$. On peut visualiser cette image $I_3$ sur un dispositif de visualisation 50.

Dans les images $I_1$ , $I_2$, ou $I_3$, un point d'image, ou pixel p, représente classiquement par sa luminosité la densité de particules contenue dans un élément de volume, ou voxel $\underline{v}$ qui lui correspond dans la tranche 70. Le voxel $\underline{v}$ comporte de nombreuses particules animées de vitesses V comportant des composantes $V_x$, $V_y$ et $V_z$ sur chacun des trois axes de référence de la machine. L'invention va permettre de calculer dans le voxel $\underline{v}$, et pour tous les autres voxels aussi, la vitesse moyenne et le nombre des particules de ce voxel ainsi en mouvement. L'image $I_3$ est représentative de cette information de vitesse, par comparaison entre deux images $I_1$ et $I_2$ où l'effet de cette vitesse aura été modulée de deux manières différentes.

Dans un premier temps, on va rappeler brièvement la théorie de l'imagerie par une méthode de type 2DFT. Dans cette méthode comme dans toutes les autres il existe des gradients perturbateurs. Dans un deuxième temps on va rappeler pourquoi cette méthode est préférée eu égard à des problèmes d'inhomogénéité du champ orientateur. Dans un troisième temps, on indiquera, dans cet exemple, comment se calculent les champs compensateurs nécessaires pour moduler l'effet de la vitesse.

Pour localiser une région d'un milieu il est nécessaire de repérer la nature de son émission en fonction de conditions locales de champ magnétique. Ces conditions locales sont imposées de façon à ce que la fréquence et la phase d'émission soient bien caractéristiques de la localisation dans l'espace de cette région du milieu. Pour cela on superpose au champ principal $B_0$ des gradients de champ magnétique pulsés. Ces gradients sont orientés selon des directions X , Y , Z pour définir à tout moment les éléments de volume qui résonnent à des fréquences connues. Pour l'acquisition d'une image entière les conditions locales sont imposées en des séquences programmées ($C_1$ , $C_2$). Celles-ci sont mises en mémoire dans un ordinateur pilote. Ces séquences définissent les instants d'application des gradients, les instants d'excitation des particules par les impulsions du champ radiofréquence, ainsi que les instants de lecture ou d'acquisition des données de l'image.

La méthode d'imagerie 2DFT permet actuellement d'obtenir la meilleure qualité d'image. Dans cette méthode d'imagerie seul un plan de coupe, le plan 7 est, excité à la fois. La figure 5 montre à cet effet des impulsions radiofréquence 100 , 110 et 120 appliquées en présence d'un gradient de champ dit de sélection, par exemple orienté selon l'axe Z, et représenté respectivement par des impulsions 130 , 140 et 150. Quand le gradient de sélection est orienté selon l'axe Z la coupe est transverse, c'est-à-dire selon un plan X , Y. Dans l'imagerie 2 DFT on code en phase les différents signaux acquis. Ceci est obtenu par une impulsion, d'intensité variable d'un gradient dit déphaseur d'axe perpendiculaire à un gradient dit de lecture dont la direction est constante. Par exemple, pour une coupe transverse, le gradient de lecture peut être sur l'axe X et le gradient de déphasage peut être sur l'axe Y. Sur la figure 5, le gradient X est coté 160, le gradient Y est coté 170. Par une double transformé de Fourier spatiale l'image est reconstruite, d'où le nom de la méthode. Une amélioration de cette méthode peut d'ailleurs permettre d'obtenir simultanément des images de plusieurs couples parallèles.

L'existence du précodage 170, qui prend un certain temps, repousse dans le temps la mesure du signal émis par le corps. Comme ce signal s'atténue très vite, on a imaginé d'en mesurer un écho. Cet écho est produit, au moment de l'application des impulsions radiofréquence 110 puis 120 par une réflexion de la dispersion de phase des contributions apportées par chacune des particules. Pour cette raison ces impulsions sont dessinées sur la figure 5 plus hautes que l'impulsion 100 puisqu'elles font basculer l'orientation des moments magnétiques des spins des particules de 180° alors que l'impulsion 100 ne les avait fait basculer que de 90°. Pour imager une coupe d'un corps il y a lieu de réaliser des séquences d'excitation d'écho de spin en présence de séquences de gradients de champ en un nombre aussi important de fois que la résolution de l'image attendue doit être plus précise. A chaque séquence d'excitation, le gradient déphaseur Y varie par pas successifs partant d'une certaine valeur jusqu'à la même valeur mais de signe opposé. Cette valeur dépend de la forme et de la durée du gradient 160 de lecture. Ce gradient déphaseur permet de faire tourner chaque moment magnétique de spin d'une phase variable, dépendant de son ordonnée suivant l'axe Y et de la valeur de ce gradient. Pour chaque image $I_1$ et $I_2$ le gradient Y peut prendre successivement le même nombre de valeurs : d'une manière préférée la définition des deux images sera la même.

Pour éviter un précodage parasite imposé par la fin 180 de l'impulsion 130, pour la partie de cette impulsion existant après la fin de l'impulsion radiofréquence 100, et par le début 190 de l'impulsion 160 de lecture il est connu d'appliquer sur ces axes respectivement des impulsions 200 et 210. L'intégrale temporelle de ces impulsions est la même mais de signe opposé, elles neutralisent l'effet parasite de codage. L'intégrale est entendue au sens d'intégrale dans le temps. Les surfaces hachurées 200 et 190 sont donc égales aux surfaces en pointillés 180 et 210 respectivement. Les impulsions 200 et 210 n'interfèrent pas dans la sélection de coupe puisqu'au moment où elles sont appliquées l'impulsion 100 n'est plus présente. Les impulsions 140 et 150 sont autoneutralisées puisqu'elles comportent des portions respectivement 220 et 230, et 240 et 250 antisymétriques par rapport au milieu de l'impulsion radiofréquence, 110 et 120 pour lesquelles elles resélectionnent la coupe 70 dans le corps 2.

La méthode d'imagerie de type 2 DFT est la plus utilisée dans la pratique du fait de sa rapidité d'acquisition (comparée à des méthodes 3D) et à sa robustesse vis-à-vis des imperfections du système physique, en particulier vis-à-vis des inhomogénéités du champ orientateur. Ceci s'apprécie particulièrement en comparaison avec des méthodes par rétroprojection ou avec des méthodes n'utilisant pas d'écho de spin. Cette méthode est en contrepartie la plus intrinsèquement sensible au déplacement des particules. L'immunité aux inhomogénéités du champ $B_0$ de la méthode 2 DFT provient du fait que contrairement aux méthodes par rétroprojection le gradient codeur en fréquence est de même direction (le gradient de lecture X) et de même amplitude, $G_L$, d'une séquence à l'autre. L'inhomogénéité du champ $B_0$ ne fait alors que déformer les lignes isofréquences de résonance. Pendant la lecture du signal, l'inhomogénéité du champ devient l'équivalent d'une mauvaise linéarité du gradient de lecture. Les images sont en conséquence distordues mais sans la création de flou et sans la perte de résolution associées que l'on rencontre avec les méthodes par rétroprojection. Dans celles-ci en effet le gradient de lecture change d'orientation à chaque séquence et de ce fait il répartit les inhomogénéités du champ orientateur dans toute l'image pour laquelle il crée ainsi un flou.

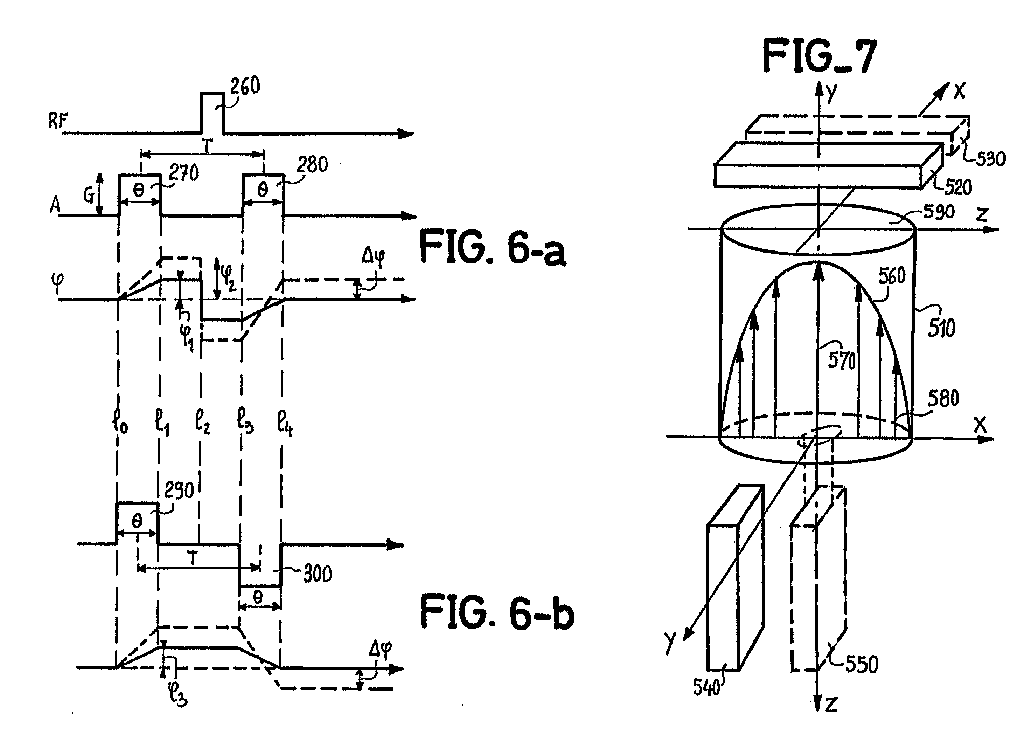

Les figures 6a et 6b montrent le déphasage $\Delta\phi$ résultant dans la contribution de signal émis par deux particules d'un même voxel soumises à des perturbations identiques, quand l'une des particules (trait plein) est immobile alors que l'autre particule (tirets) est animée d'une vitesse V. La figure 6a montre le diagramme temporel d'un signal radiofréquence RF comportant une impulsion 260 pour créer un écho de spin. Selon un axe A un gradient de champ magnétique a été imposé en prenant avant et après l'impulsion 260, par exemple, une valeur G pendant une durée $\theta$ à chaque fois. En un lieu donné $I_0$ une particule préalablement excitée, immobile, vibre à une fréquence $f_0$ au début de l'application de l'impulsion 270. Pendant la durée $\theta$ de cette impulsion 270 elle vibre à une fréquence différente. Par exemple cette fréquence est supérieure, de telle manière qu'à la fin de l'impulsion 270 on puisse considérer, puisqu'elle se remet à vibrer à la fréquence $f_0$ qu'elle a subi un déphasage $\phi_1$. Lors de l'application de l'impulsion radiofréquence 260 on peut admettre que tout se passe comme si la phase du signal émis par cette particule s'inversait : $-\phi_1$. Pendant l'impulsion 280 qui a exactement la même allure que l'impulsion 270 le phénomène de déphasage continue : la contribution se déphase encore de $\phi_1$. Mais ce dernier déphasage vient effacer l'effet du premier après qu'il ait été inversé par l'impulsion 260. En conséquence, la particule immobile en $I_0$ retrouve à la fin de l'impulsion 280 la phase qu'elle avait au début de l'impulsion 270. Il est utile de remarquer que le déphasage $\phi_1$ est proportionnel d'une part à l'amplitude du gradient G et d'autre part à la durée pendant laquelle chaque impulsion du gradient est imposée. Plus généralement $\phi_1$ est proportionnel à l'intégrale de ce gradient pendant la durée d'existence de son impulsion si cette impulsion n'est pas exactement carrée.

Il en va tout autrement pour une deuxième particule, toute voisine dans le même voxel de la particule précédente, et qui par contre est animée d'une vitesse V. Sur la figure 6a, on a indiqué que cette particule se trouvait successivement dans les positions $I_0$ à $I_4$ au début et à la fin de la première impulsion 270, au moment de l'impulsion radiofréquence 260, et au début et à la fin de la deuxième impulsion 280 du gradient. Après la première impulsion 270 de gradient, le déphasage résultant $\phi_2$ est proportionnel au gra-

dient G et à la durée θ Mais il est aussi proportionnel à la distance $l_1 - l_0$ parcourue dans l'intervalle par la particule. Cette distance est égale à V. θ. Ce qui fait que le temps intervient maintenant au carré : la première portion de déphasage à l'allure d'une parabole (V.G.θ²). De la fin de l'impulsion 270 au début de l'impulsion 280, tout se passe comme pour la particule immobile : la contribution possède une phase - $\phi_2$ au début de l'impulsion 280. Au cours de cette impulsion 280 l'évolution de la phase est également parabolique comme pour l'impulsion 270. On pourrait s'attendre à ce que les effets de phase s'effacent ici également. Cependant entre la fin de l'impulsion 270 et le début de l'impulsion 280 la particule animée s'est déplacée de la position $l_1$ à la position $l_3$. Dans la position $l_3$ au moment où l'impulsion 280 apparaît, et du fait de l'existence du gradient de champ, les conditions locales de champ ne sont plus les mêmes que celles qui avaient prévalu quand la particule s'était trouvée entre $l_0$ et $l_1$. En conséquence à la fin de l'impulsion 280 la compensation ne s'opère pas et cette particule animée émet alors un signal déphasé d'une valeur $\Delta\phi$ que l'on peut écrire de la manière suivante :

$$\Delta\varphi = \gamma \cdot G(\theta) \cdot V \cdot T.$$

où $\gamma$ est le rapport gyromagnétique des particules considérées, où G (θ) représente le gradient dans les impulsions 270 et 280, et où T est la durée qui sépare l'apparition de ces deux impulsions. Si θ n'est pas petit, T mesure la durée entre les milieux de ces impulsions. Plus généralement on peut écrire :

$$\Delta\varphi(t) = V \cdot \int_0^t \gamma \cdot G(\tau) \cdot \tau \cdot d\tau$$

où le déphasage est donné maintenant en fonction du temps et où G(τ) représente toutes les perturbations appliquées aux particules avant qu'on en mesure à une date t le signal qu'elles émettent. On se souvient simplement que les perturbations considérées sont telles que :

$$\int_0^t G(\tau) \, d\tau = 0$$

Car c'est sous cette condition que, d'une manière connue dans l'état de la technique (figure 5 impulsions 180 à 250), on a compensé les précodages parasites. On ne l'avait bien entendu pas fait pour l'impulsion variable 170 puisque le déphasage qu'elle provoque pour le signal global est, d'une acquisition à l'autre, une des caractéristiques permettant l'imagerie.

En l'absence d'une impulsion radiofréquence telle que 260 créant un écho de spin (figure 6b), les impulsion 270 et 280 du gradient bipolaire doivent être remplacées par des impulsions 290 , 300 de signes opposés. De cette manière la phase pour les particules fixes évolue jusqu'à $\phi_3$ en fin de l'impulsion 290 et évolue en sens inverse jusqu'à zéro au cours de l'impulsion inverse 300. Le déphasage $\Delta\phi$ entre la contribution des particules mobiles et celles des particules fixes est du même ordre que précédemment.

Dans l'expression de $\Delta\phi$ (t), G (τ) représente donc toutes les séquences nécessitées par la mesure. Ce qui caractérise le perfectionnement c'est que ces séquences sont maintenues telles quelles mais que leurs effets sur la vitesse sont compensés par l'adjonction de séquences supplémentaires de gradients de champ G' dits compensateurs tels que

$$\int_0^t (G(\tau) \cdot \tau + G'(\tau) \cdot \tau) \, d\tau = 0$$

où G' représente des gradients, eux aussi bipolaires, c'est-à-dire tels que

EP 0 208 601 B1

$$\int_{0}^{t} G'(\tau)\,d\tau = 0\ .$$

Autrement dit en agissant ainsi on annule le coefficient multiplicateur de la vitesse V qui apparaît dans le calcul de $\Delta\phi$ (t). Du coup, quelle que soit cette vitesse, $\Delta\phi$ (t) est nul : toutes les contributions sont en phase. Les particules mobiles sont prises en compte comme si elles étaient fixes. Il faut cependant remarquer que seules les modifications du signal dues à des vitesses V, constantes pendant la mesure, sont ainsi annulées. Ceci est en particulier le cas pour les micro-circulations de cellules de sang. Par contre, avec la diffusion, la vitesse de protons au cours d'une même séquence ($NT_{E'}$, $T_E$) n'est pas constante. Donc le terme V ne peut être sorti de l'expression de $\Delta\phi$. La compensation de G par G' ne peut pas se produire. Dans ces conditions, l'atténuation du signal de résonance, due à la diffusion, persiste. Elle est mesurée et sa mesure permet la différenciation du milieu étudié. Il est à noter que le phénomène de micro-circulation est particulièrement présent dans les angiomes et les tumeurs. D'où l'intérêt de supprimer ses effets pour mesurer correctement la diffusion. Par ailleurs, on peut quantifier l'intensité des micro-circulations par comparaison d'une image de diffusion non compensée en vitesse à une image de diffusion compensée en vitesse. En effet la première image est une image de diffusion et de micro-circulation alors que la deuxième n'est qu'une image de diffusion pure. La soustraction des deux images, si leurs caractéristiques sont égales, conduit à une image de micro-circulation.

En revenant à la figure 5 on voit sur chaque axe X , Y , Z l'adjonction de tels gradients bipolaires compensateurs sous la forme préférée de couples d'impulsions notés 310 et 320 , 330 et 340 , 350 et 360 , 370 et 380 , 390 et 400 et 420 et 430. L'incidence de ces impulsions compensatrices est symbolisée dans le dessin par la présence de petites croix. On sait, dans les machines de l'état de la technique imposer de telles impulsions en modifiant les commandes $C_1$ ou $C_2$ des moyens générateurs. L'intégrale dans le temps des impulsions de chaque couple est nulle. D'une manière préférée, puisque l'impulsion de correction de précodage 200 sur l'axe de sélection Z est appliquée entre des dates $t_1$ et $t_2$ à la fin de l'impulsion 130, on applique l'impulsion 310 pendant la même période. Dans ce cas l'impulsion 200 "nouvelle" est plus forte. Les impulsions 350 et 370 sont également appliquées pendant cette période. Les impulsions 320 , 360 et 380 d'une manière préférée sont appliquées entre la fin $t_3$ de l'impulsion 140 et le début $t_4$ de l'impulsion de lecture 160. Les impulsions 330 , 390 et 420 sont appliquées entre la fin $t_5$ de l'impulsion 160 et le début $t_6$ de l'impulsion 150. Les impulsions 340 , 400 et 430 sont appliquées entre la fin $t_7$ de l'impulsion 150 et le début $t_8$ d'une impulsion 410 qui sert à la lecture d'un deuxième écho.

Sur le plan pratique, la mesure du signal émis est effectuée entre des dates $t'_4$ et $t'_5$ contenues entre les dates $t_4$ et $t_5$ et aussi pendant la durée de l'impulsion 410. Bien entendu les impulsions de compensation appliquées sur un axe, X , Y ou Z ont pour objet d'effacer l'effet des gradients perturbateurs appliqués sur le même axe. L'expression intégrale donne implicitement les gradients G' ; il est possible de faire des simplifications. Premièrement tous les termes en G $(\tau).\tau$ sont des termes connus (ils appartiennent à la séquence 2DFT) : leur intégrale l'est également. Cette intégrale peut donc être sortie de l'expression. D'une manière préférée les formes des impulsions compensatrices 310 à 430 seront des formes connues et, dans la mesure du possible, identiques à des formes déjà pratiquées pour les impulsions normales des séquences perturbatrices. Compte-tenu des dates retenues pour l'application de ces impulsions, une intégrale unitaire de chacune d'elle peut être calculée et l'expression de G' peut s'écrire d'une autre manière :

$$\int_{t} G(\tau).\tau\,d\tau + \lambda \int_{0}^{t} \Gamma(\tau).\tau\,d\tau = 0$$

Le premier membre est connu il concerne les gradients perturbateurs. Le deuxième membre comporte des intégrales de gradients de forme préférée $\Gamma$ et d'amplitude unité. On sait calculer l'intégrale du deuxième membre puisqu'on connaît la forme choisie $\Gamma$. En conséquence on peut en déduire $\lambda$ c'est-à-dire l'amplitude des impulsions compensatrices.

Dans le cas de l'imagerie conventionnelle, où un gradient au moins est appliqué pendant la période de lecture ($t'_4$ , $t'_5$), l'équation implicite contenant G' ne peut être vérifiée pour tout $t$. Mais on doit au moins la vérifier aux temps $t_{E_1}$ , $t_{E_2}$... centre des phases de mesure. Ces dates sont celles où l'écho de spin attendu est le plus fort. Elles sont telles que la durée séparant la date de l'impulsion radiofréquence 100 et $t_{E_1}$ est le double de la durée entre l'impulsion 100 et l'impulsion 110, et telles que la durée entre la date $t_{E_1}$ et la date $t_{E_2}$ est égale au double de la durée entre la durée $t_{E_1}$ et la date de l'impulsion radiofréquence 120.... La justification de ces dates est, d'une part, intuitive et, d'autre part, théorique. L'idée conductrice en ce domaine est que l'on cherche à connaître l'état de la coupe 70 non pas au moment de son excitation (impulsion 100) mais au moment, $t_{E_1}$ ou $t_{E_2}$, où justement on effectue la mesure : au centre du signal émis.

Tous les termes de l'équation implicite donnant G' étant connus, G' est calculable. Sur la figure 5 on va donner une approche simple de ce calcul. Pour l'axe X on sait que les impulsions 210 et 190 situées de part et d'autre de l'impulsion radiofréquence 110 neutralisent mutuellement leurs effets de précodage : l'intégrale de la somme de ces impulsions est nulle. Par contre l'intégrale du produit de ces impulsions par la durée qui les sépare de la date du relevé, $t_{E_1}$, n'est pas nulle : l'impulsion 210 étant plus antérieure dans le temps que l'impulsion 190. Tout se passe donc comme si l'impulsion 210 de "force" donnée est appliquée à un "bras de levier" plus long que l'impulsion 190 de force égale. L'effet sur la phase de l'impulsion 190 est bien entendu inverse de celui de l'impulsion 210 puisqu'elles sont situées de part et d'autre de l'impulsion 110. En conséquence leur effet commun sur la phase s'analyse comme un moment orienté dans le sens de l'impulsion ayant le plus grand bras de levier : l'impulsion 210. Il convient de contrecarrer ce moment résultant par un couple d'impulsions 350 , 360 dont l'intégrale totale est nulle (il ne provoque aucun déphasage sur le signal des parties fixes) mais dont le moment global s'oppose au moment global des deux impulsions 210 et 190. Ainsi, l'impulsion 350 étant placée dans le temps à une date plus antérieure que l'impulsion 360 par rapport à la date $t_{E_1}$ son effet est prépondérant. Il est bien de sens opposé à l'impulsion 210.

De la même façon sur l'axe de sélection Z, des impulsions 180 et 200 , et 220 et 230, ce sont à chaque fois les impulsions 180 et 220 qui priment : leur bras de levier est plus long. En conséquence on conçoit bien que l'impulsion 310 doit être dans le même sens que l'impulsion 200. Le cas des impulsions 370 et 380 est un peu différent. En effet elles doivent contrecarrer les effets d'un gradient qui varie d'une acquisition à l'autre. Les amplitudes des impulsions 370 et 380 varieront donc également en correspondance d'une acquisition à l'autre (symbolisé par des flèches). Pour les raisons précédentes quand l'impulsion 170 est positive l'impulsion 370 doit être négative. Pour pouvoir réduire les amplitudes des impulsions compensatrices on cherche bien entendu à donner à leur moment le plus d'efficacité possible : on essaie d'augmenter la durée qui sépare leur application de la date du relevé. On les place le plus en amont possible de la séquence pour la première (310 , 350 , 370) et le plus en aval pour la deuxième (320 , 360 , 380). En conclusion elles sont le plus éloignées possible de part et d'autre de l'impulsion radiofréquence 110 ; et elles sont le plus éloignées possible l'une de l'autre.

Lors du premier relevé, en $t_{E_1}$, les effets de vitesse des parties mobiles ont été complètement compensés. On compense maintenant au moyen des impulsions 330 et 340 les effets de la deuxième impulsion de sélection 150. La date pivot pour le calcul des moments est maintenant la date $t_{E_2}$. Sur l'axe de lecture X on compense également par deux impulsions 420 et 430 les effets de la deuxième moitié 600 de l'impulsion 160 et de la première moitié 610 de l'impulsion 410. La présence des impulsions compensatrices 390 et 400 sur l'axe Y se justifie par le fait que l'impulsion 170 n'est pas bipolaire. Car la compensation de son moment à la date pivot $t_{E_1}$ par les impulsions 370 et 380 n'implique pas une telle compensation à une autre date pivot telle que $t_{E_2}$. Et ceci bien qu'aucune impulsion supplémentaire de perturbation n'intervienne sur cet axe entre temps.

La figure 7 représente un tube d'écoulement 510 sensé se trouver dans la tranche examinée 70 du corps 2. Le haut de la figure représente une situation dans laquelle le tube 510 est coplanaire au plan X , Y de la coupe. Dans la partie basse de la figure la situation est différente : le tube 510 est supposé être perpendiculaire au plan X et Y de la coupe. De part et d'autre sont représentés des voxels notés 520 à 550. Ces voxels ont la forme de parallélépipèdes rectangles ayant une forme de section sensiblement carrée. La section est carrée dans la mesure où, dans l'imagerie, l'échantillonnage représentatif est effectué avec la même résolution selon l'axe X et l'axe Y du plan de coupe. La grande longueur du parallélépipède rectangle s'étend selon l'axe Z. Cette longueur est liée à l'épaisseur de la coupe 70. Cette épaisseur est un compromis expérimental entre la finesse de résolution des coupes et la quantité de signal global mesurable. Plus la coupe est épaisse plus le signal mesurable est élevé, et bien entendu moins l'image est précise. Dans la pratique la grande dimension est de l'ordre de 7 à 15 mm, la section carrée est de l'ordre de 1 mm par 1 mm.

Dans le conduit 510 un fluide non représenté circule avec un diagramme de vitesse 560. Les vitesses 570 des particules situées au centre sont plus élevées que les vitesses 580 des particules situées sur les bords du conduit. Dans les artères la vitesse 570 peut être de l'ordre de 50 cm par seconde. Les voxels 520 et 530 comportent, quand ils sont situés à l'aplomb de la section 590 du conduit 510, nécessairement des particules animées avec des vitesses très différentes. Avant l'invention l'étalement du spectre de vitesse était tellement important que la contribution des voxels 520 et 530 dans le signal global était nulle : on avait l'impression que le tube était creux. L'image des voxels 540 et 550 pouvait dans certains cas être révélatrice. Elle l'était dans la mesure où ces voxels se situaient à l'aplomb de la partie de la section du conduit où l'étalement du spectre des vitesses était faible. C'est le cas pour le voxel 550 où les vitesses (au centre du tube) tout en étant élevées sont relativement homogènes entre elles. Leur déphasage correspondant est sensiblement le même : la moyenne n'est pas nulle. Par contre pour le voxel 540 situé à l'aplomb du bord du conduit 510, là ou l'évolution des vitesses est brutale, le signal restitué est nul. Il en résultait que l'image des tubes 510 perpendiculaires au plan de coupe était appréciée géométriquement plus petite qu'elle n'était en réalité. Avec le perfectionnement l'image des écoulements est révélée fidèlement.

Un autre perfectionnement a été apporté à l'invention. Les inventeurs se sont rendus compte en effet, à l'expérience, que la compensation de vitesse du sang dans les capillaires liée à la micro-circulation, pour ne faire apparaître que le phénomène de diffusion seul, n'était pas toujours efficace parce que les vitesses de micro-circulation dans le tissu n'étaient pas constantes en valeur et en direction pendant le temps de mesure (temps d'écho). La constance en direction est liée à la géométrie du réseau capillaire dans le tissu étudié : par exemple la direction de la micro-circulation dans un muscle peut-être constante ( vaisseaux rectilignes) sur une distance supérieure à la distance parcourue par le sang pendant le temps de mesure. Par contre pour d'autres tissus, comme dans le cerveau humain, la micro-circulation (on dit aussi quelques fois la perfusion) est orientée en tous sens. L'enchevêtrement des réseaux de capillaires y est même tel que, malgré la rapidité des mesures RMN (une séquence excitation-mesure peut durer typiquement 100 ms) les orientations des vitesses de déplacement des molécules changent de direction pendant la mesure : ce qui peut-être interprété comme une macro-diffusion à l'échelle d'un voxel. Autrement dit la représentation dans l'image du paramètre de diffusion D du tissu est faussée : le coefficient représenté contient une composante liée à la valeur de la diffusion vraie (D) pour la part statique du tissu et une composante (D') liée à la présence de la micro-circulation dans un voxel donné.

Si on appelle $\underline{f}$ la proportion de fluide circulant dans les capillaires et (I-f) la proportion du reste du tissu dans un voxel donné, on peut dire que la contribution de signal mesurée relative à ce voxel peut s'écrire :

- pour une séquence peu diffusante (peu sensible à la diffusion et au phénomène de micro-circulation)

$S_N = (1-f)S(\rho, T_1, T_2).A + f.S'(\rho, T_1, T_2).A.F_N$ (avec Nechos, $N \geqslant 1$)

- et pour une séquence diffusante :

$S_1 = (1-f)S(\rho, T_1, T_2).e^{-bkm \cdot D} + f.S'(\rho.T_1.T_2).F_1.e^{-bkm.D}$

Dans ces formules $S(\rho, T_1, T_2)$ et $S'(\rho, T_1, T_2)$ représentent le signal de RMN respectivement pour le tissu (le tissu du cerveau) et pour le fluide des capillaires actifs. La valeur $A = e^{bNm \cdot D}$ représente l'effet de la diffusion pendant les premières séquences (N , m). Comme les premières séquences sont peu diffusantes A vaut 1 et est par la suite négligé dans les calculs. La fonction F, égale à 1 pour les séquences peu diffusantes, a une valeur inférieure à 1 en cas de séquences diffusantes. Elle dépend des gradients, de la vitesse du sang dans la micro-circulation, et de la géométrie des capillaires. Quand les capillaires sont rectilignes (sur une distance fonction du temps de mesure) mais avec des orientations différentes au sein d'un même voxel, F est un sinus cardinal du gradient et de la vitesse de micro-circulation. Quand la distance moyenne pour laquelle un capillaire peut être considéré comme rectiligne est inférieure à la distance parcourue pendant le temps de mesure on peut écrire :

$$F_1 = e^{-b_{km} \cdot D'}$$

La micro-circulation est assimilée a une macro-diffusion.

Dans l'autre perfectionnement ainsi apporté on s'est rendu compte que $F_1$, lié à la micro-circulation, pouvait être bien plus petit que $e^{-bkm \cdot D}$ lié à la diffusion D vraie à connaître. On s'arrange alors pour que $b_{km}$, qui dépend de la forme et de la force des gradients dans la séquence diffusante, soit suffisant pour rendre l'atténuation $e^{-bkm \cdot D}$ sensible (au point qu'on peut mesurer D) et soit à ce point fort que $f.F_1$ puisse être considéré comme négligeable. Dans un exemple préféré $b_{km}$ correspond à un $\underline{k} = 1$ : les séquences diffusantes comportent de préférence un seul écho de spin $\underline{(m}$ correspondant au nombre de paires de gradients homologues compensés, aussi dits bipolaires, de la séquence). Dans ce cas on peut dire que le coefficient de diffusion mesuré $D_m$ est, en application de la formule précédente donnée au début de cette description, tel que :

$$D_m = \frac{1}{b_{km}} \cdot \text{Log} \frac{(1-f)S + f.S'}{(1-f)S.e^{-b_{km} \cdot D}} + (0 : \text{négligé})$$

En supposant que S est voisin de S', on peut simplifier par S (ou S'), et l'expression de $D_m$ devient :

$$D_m = D - \frac{1}{b_{km}} \cdot \text{Log}(1-f)$$

Cette expression est une équation à deux inconnues, D et f, dont on peut trouver une solution en réitérant les expériences de manière à mesurer deux valeurs de Dm pour deux valeurs de $b_{km}$ différentes. Du système de deux équations à deux inconnues obtenu on extrait D et $\underline{f}$. Les deux valeurs de $b_{km}$ rete-

nues sont conformes par ailleurs aux indications données ci-dessus relatives à la nécessité de rendre f.F₁ négligeable.

Autrement dit le nouveau procédé, ainsi mis en oeuvre pour procurer les fruits de cet autre perfectionnement, doit comporter :

- un (premier) ensemble de séquences d'un premier type (des premières séquences peu diffusantes),
- un (deuxième) ensemble de séquences d'un deuxième type (des deuxièmes séquences diffusantes),
- et un (troisième) ensemble de séquence du deuxième type (des deuxièmes séquences, là aussi diffusantes, mais dont les caractéristiques de diffusion, $b_{km}$, sont changées). La première valeur de $D_m$ est tirée de la comparaison du signal de RMN résultant du premier ensemble de séquences au signal de RMN résultant du deuxième ensemble de séquences. La deuxième valeur de $D_m$ est tirée de la comparaison du signal de RMN résultant du premier ensemble de séquences au signal de RMN résultant du troisième ensemble de séquences. Il est inutile en effet de réitérer le premier ensemble de séquences. La valeur vraie D de la diffusion en chaque point est extraite du système des deux équations a deux inconnues qui vaut pour ce point. On sait résoudre un tel système d'équations. On peut aussi par le procédé de l'invention connaître $\underline{f}$, ou l-f ce qui revient au même. Il est à noter que la connaissance de ce paramètre peut aussi être intéressante pour établir un diagnostic. On obtient finalement deux images : une de diffusion vraie D, l'autre de perfusion $\underline{f}$ (en fait de la proportion de capillaires actifs dans le tissu, dans chaque voxel). Le cas échéant, les séquences diffusantes peuvent aussi être compensées en vitesse si une composante rectiligne de la vitesse dans les capillaires est remarquée. Dans ce cas, du fait de la compensation, $F_1$ devient égal à 1.

On remarque en outre que pour le deuxième et le troisième ensemble de séquences (diffusantes) f. $F_1$ est négligeable. En effet pour ces séquences la valeur (forme et force) des gradients est adaptée à cette contrainte. On peut alors comparer point à point le signal de RMN relatif à ces séquences. Soit $S_1$ et $S'_1$ le signal relatif, en chaque point, respectivement aux deuxième et troisième séquences, on peut écrire:

$$S_1 = (1 - f) S (\rho, T_1, T_2) e^{-b_{km}D}$$

$$S'_1 = (1 - f) S (\rho, T_1, T_2) e^{-b_{k'm'}D}$$

puisque la contribution de la micro circulation dans chaque pixel est négligeable. Il en resulte que :

$$\frac{S_1}{S'_1} = e^{-(b_{km}-b_{k'm'}) D},$$

D'où on extrait D vrai. Dans ces conditions, on élimine les parasites de micro circulation, tout en ne faisant que deux séquences, mais deux séquences diffusantes ($S_1$, $S'_1$), avec des caractéristiques de diffusion différentes. En conséquence quand on dit, en particulier dans les revendications ; que le procédé de l'invention comporte des séquences peu diffusantes et des séquences diffusantes il faut entendre en fait, toutes choses étant égales par ailleurs, des séquences moins diffusantes et des séquences plus diffusantes.

En outre trois cas peuvent se présenter :
- premier cas - les capillaires du tissu sont rectilignes et parallèles-on obtient alors l'image de diffusion vraie avec une séquence non diffusante et une séquence diffusante compensée.
- deuxième cas - les capillaires ne sont pas rectilignes - on obtient alors l'image de diffusion vraie D, ou l'image de perfusion $\underline{f}$, avec les trois séquences (dont deux diffusantes) et il ne sert à rien de compenser.
- troisième cas - les capillaires sont rectilignes mais dans tous les sens - on obtient l'image de diffusion vraie comme dans le premier cas ou comme dans le deuxième cas. Le deuxième cas nécessite une acquisition supplémentaire de l'image (en faisant varier $b_{km}$) ce qui est plus long mais qui donne l'avantage de proposer en outre l'image de perfusion $\underline{f}$.

## Revendications

1. Procédé d'imagerie par résonance magnétique nucléaire (1-9, 50) comportant les étapes suivantes pour donner une image ($I_3$) de la diffusion moléculaire d'un corps étudié :
- on place le corps (2) dans un champ magnétique constant ($B_0$);
- on soumet (3-4, $C_1$) le corps ainsi placé à une première pluralité de premières séquences d'excitations à écho de spin en présence de premières séquences de gradient de champ ; ces premières séquences à écho de spin comportant un nombre entier N supérieur ou égal à 1 d'excitations (16-19) où les moments magnétiques des noyaux sont basculés de 180° après une excitation (15) où ces moments ont été basculés de 90° pour faire ainsi des séquences à N échos peu diffusantes ;
- on relève (4,5) les signaux de résonance magnétique en fin de cespremières séquences d'excitations et on calcule (6) une première image (I₁) correspondant aux échos N de ces signaux en attribuant à chaque point de l'image une valeur (S$_N$) correspondant au signal de résonance magnétique du point qui lui correspond dans le corps;
- on soumet (3-4, C₂) le corps ainsi placé à une deuxième pluralité de deuxièmes séquences d'excitations à écho de spin en présence de deuxièmes séquences de gradient de champ ; ces deuxièmes séquences à écho de spin comportant au moins une excitation à 180° (26) après l'excitation à 90° (15) pour faire des séquences à au moins un écho diffusantes ; la durée totale d'écho (T$_E$) des deuxièmes séquences d'excitations étant égale à la durée totale d'écho (N.T$_{E'}$) des premières séquences d'excitations ;
- on relève (4,5) les signaux de résonance magnétique en fin de ces deuxièmes séquences d'excitations et on calcule (6) une deuxième image (I₂) correspondant aux échos de ces signaux en attribuant à chaque point d'image une valeur correspondant au signal de résonance magnétique du point qui lui correspond dans le corps.;
- on compare (7) point à point les valeurs attribuées pour la première image aux valeurs attribuées pour la deuxième image, pour élaborer une troisième image (I₃) représentative de la diffusion moléculaire en chaque point du corps.

2. Procédé selon la revendication 1, caractérisé en ce que les deuxièmes séquences comportent des impulsions plus longues et/ou plus fortes (41-48) de gradients de champ hors présence des excitations d'écho de spin et orientés selon un axe pour constituer des suppléments de gradient de champ.

3. Procédé selon la revendication 2, dans lequel les séquences de gradient de champ comportent des impulsions de gradient de champ orienté selon trois axes (X,Y,Z) : l'axe (Z) du champ constant (B₀), ou axe de sélection, et deux axes (X,Y) orthogonaux à cet axe appelés respectivement axe de codage de phase (Y) et axe de lecture (X), dans lequel la méthode de calcul des images est du type 2DFT, caractérisé en ce que l'axe des suppléments est l'axe de lecture.

4. Procédé selon la revendication 2, dans lequel les séquences de gradient de champ comportent des impulsions de gradient de champ orienté selon trois axes (X,Y,Z) : l'axe (Z) du champ constant (B₀), ou axe de sélection, et deux axes (X,Y) orthogonaux à cet axe appelés respectivement axe de codage de phase (Y) et axe de lecture (X), dans lequel la méthode de calcul des images est du type 2DFT, caractérisé en ce que l'axe des suppléments est l'axe de sélection.

5. Procédé selon la revendication 2, dans lequel les séquences de gradient de champ comportent des impulsions de gradient de champ orienté selon trois axes (X,Y,Z) : l'axe (Z) du champ constant (B₀), ou axe de sélection, et deux axes (X,Y) orthogonaux à cet axe appelés respectivement axe de codage de phase (Y) et axe de lecture (X), dans lequel la méthode de calcul des images est du type 2DFT, caractérisé en ce que l'axe des suppléments est l'axe de codage de phase.

6. Procédé selon l'une quelconque des revendications 1 à 5, caractérisé en ce qu'il est mis en oeuvre à plusieurs reprises pour réaliser des troisièmes images multicoupes du corps étudié.

7. Procédé selon l'une quelconque des revendications 2 à 6, caractérisé en ce que les instants d'application des suppléments de gradient sont le plus éloignés possible dans le temps des excitations radio-fréquence à 180°.

8. Procédé selon l'une quelconque des revendications 1 à 7, caractérisé en ce qu'on place à côté du corps un corps étalon (33) pour calibrer les calculs de la troisième image.

9. Procédé selon l'une quelconque des revendications 1 à 8, caractérisé en ce que les durées de temps d'écho (T$_{E'}$) des premières séquences d'écho de spin sont toutes égales entre elles.

10. Procédé selon l'une quelconque des revendications 1 à 9, caractérisé en ce que N vaut 4.

11. Procédé selon la revendication 2, caractérisé en ce qu'on réitère les étapes relatives à la deuxième image avec des suppléments de gradient orientés selon un autre axe pour élaborer une autre troisième image pour déterminer la nature des régions imagées.

12. Procédé selon l'une quelconque des revendications 1 à 11, caractérisé en ce que pour la comparaison point par point, on calcule le logarithme du rapport desdites valeurs.

13. Procédé selon l'une quelconque des revendications 1 à 12, ou 21 ou 22, caractérisé en ce qu'on module l'effet de la vitesse (V) des parties mobiles du corps créé par des séquences de gradient de champ dits perturbateurs par l'application, avant le relevé (t$_{E1}$), d'une séquence (310 - 430) d'un champ magnétique compensateur dont l'intégrale calculée sur sa durée est nulle, et dont l'historique et la valeur sont fonction de l'historique et de la valeur des champs perturbateurs.

14. Procédé selon la revendication 13, caractérisé en ce que la séquence du champ magnétique perturbateur comporte des impulsions de champ magnétique selon trois axes orthogonaux (X , Y , Z), et en ce que la séquence du champ magnétique compensateur comporte des impulsions de champ magnétique selon ces trois mêmes axes, pour moduler un à un les effets de la vitesse des parties mobiles du corps selon ces trois mêmes axes.

15. Procédé selon la revendication 14, caractérisé en ce que les impulsions de champ magnétique compensateur sont déterminées à priori en forme, en durée, et en position, et en ce que leur amplitude est évaluée pour obtenir la modulation recherchée.

16. Procédé selon la revendication 13 ou 14 ou 15, caractérisé en ce que la séquence des champs magnétiques compensateurs comporte des couples bipolaires d'impulsions.

17. Procédé selon l'une quelconque des revendications 13 à 16, caractérisé en ce que la séquence des champs magnétiques compensateurs comporte des couples d'impulsions, chaque impulsion d'un couple étant de valeur, de forme, de durée, et de signe égal à l'autre impulsion du couple, et ces impulsions se trouvant respectivement avant et après une deuxième excitation radio-fréquence.

18. Procédé selon l'une quelconque des revendications 13 à 17, caractérisé en ce que l'intégrale du produit de la valeur des impulsions de champ perturbateur par la durée qui les sépare du relevé du signal émis est compensée par l'intégrale d'un même produit obtenu avec les impulsions de champ compensateur.

19. Procédé selon la revendication 16 ou 17, caractérisé en ce que les impulsions des couples d'impulsion comportent des impulsions les plus éloignées possible l'une de l'autre.

20. Procédé selon l'une quelconque des revendications 13 à 19, caractérisé en ce qu'on module l'effet de la vitesse des parties mobiles du corps créé seulement par les deuxièmes séquences de gradient de champ.

21. Procédé selon la revendication 1 caractérisé en ce que :
- on soumet le corps ainsi placé à une troisième pluralité de troisième séquences d'excitation à écho de spin en présence de troisièmes séquences de gradient de champ ; les troisièmes séquences à écho de spin comportant au moins une excitation à 180 ° après l'excitation à 90 ° pour faire des séquences à au moins un écho diffusantes ; la durée totale d'écho des troisièmes séquences d'excitation étant égale à la durée totale d'écho des premières séquences d'excitation ; les troisièmes séquences de gradient de champ étant différentes des deuxièmes séquences de gradient de champ ;
- on relève les signaux de résonance magnétiques en fin de ces troisièmes séquences d'excitation et on calcule une quatrième image correspondant aux échos de ces signaux en attribuant à chaque point d'image une valeur correspondant au signal de résonance magnétique du point qui lui correspond dans le corps ;
- on compare point à point les valeurs attribuées pour la première image aux valeurs attribuées pour la quatrième image pour élaborer une cinquième image représentative de la diffusion moléculaire en chaque point du corps ;
- on compare point à point les valeurs attribuées pour la troisième image aux valeurs attribuées pour la cinquième image pour élaborer une sixième image représentative de la diffusion moléculaire vraie dans le corps et exempte de parasites de micro-circulation.

22. Procédé selon la revendication 1 caractérisé en ce que :
- on soumet le corps ainsi placé à une troisième pluralité de troisièmes séquences d'excitation à écho de spin en présence de troisièmes séquences de gradient de champ : les troisièmes séquences à écho de spin comportant au moins une excitation à 180° après l'excitation à 90° pour faire des séquences à au moins un écho diffusantes ; la durée totale d'écho des troisièmes séquences d'excitation étant égale à la durée totale d'écho des premières séquences d'excitation; les troisièmes séquences de gradient de champ étant différentes des deuxièmes séquences de gradient de champ ;
- on relève les signaux de résonance magnétiques en fin de ces troisièmes séquences d'excitation et on calcule une quatrième image correspondant aux échos de ces signaux en attribuant à chaque point d'image une valeur correspondant au signal de résonance magnétique du point qui lui correspond dans le corps ;
- on compare point à point les valeurs attribuées pour la première image aux valeurs attribuées pour la quatrième image pour élaborer une cinquième image représentative de la diffusion moléculaire en chaque point du corps ;
- on compare point à point les valeurs attribuées pour la troisième image aux valeurs attribuées pour la cinquième image pour élaborer une septième image repésentative d'un phénomène de perfusion dans le corps.

23. Procédé selon les revendications 21 et 22 caractérisé en ce qu'on élabore simultanément la sixième et la séptième image.

24. Procédé selon l'une quelconque des revendications 1 à 23 caractérisé en ce que les séquences diffusantes sont des séquences à un seul écho de spin.

## Patentansprüche

1. Verfahren zur Abbildung durch magnetische Kernresonanz (1–9, 50), welches die folgenden Schritte umfaßt, um ein Bild ($I_3$) der molekularen Streuung eines beobachteten Körpers abzugeben:
– der Körper (2) wird in ein konstantes Magnetfeld ($B_0$) gebracht;
– der so angeordnete Körper wird einer ersten Vielzahl von Spinecho-Anregungssequenzen in Anwesenheit von ersten Feldgradient-Sequenzen ausgesetzt (3–4, $C_1$); wobei diese ersten Spinecho-Sequenzen eine ganze Zahl N von Anregungen (16–19), welche größer als oder gleich 1 ist, umfassen, bei welcher die magnetischen Momente der Kerne um 180° verschwenkt werden, nach einer Anregung (15), bei der diese Momente um 90° verschwenkt werden, um auf diese Weise schwach streuende Sequenzen mit N Echos zu bilden;

– die Signale der magnetischen Resonanz werden am Ende dieser ersten Anregungssequenzen aufgenommen (4, 5) und ein erstes, den N-Echos dieser Signale entsprechendes Bild ($I_1$) wird berechnet (6), indem jedem Punkt des Bildes ein Wert ($S_N$) zugewiesen wird, welcher dem Signal der magnetischen Resonanz des Punktes entspricht, der ihm in dem Körper entspricht;

– der so angeordnete Körper wird einer zweiten Vielzahl von zweiten Spinecho-Anregungssequenzen in Anwesenheit von zweiten Feldgradient-Sequenzen ausgesetzt (3–4, $C_2$); wobei diese zweiten Spinecho-Sequenzen wenigstens eine Anregung um 180° (26) nach der Anregung um 90° (15) umfassen, um streuende Sequenzen mit wenigstens einem Echo zu bilden; wobei die gesamte Echodauer ($T_E$) der zweiten Anregungssequenzen der gesamten Echodauer ($N.T_E'$) der ersten Anregungssequenzen entspricht;

– die Signale der magnetischen Resonanz werden am Ende dieser zweiten Anregungssequenzen aufgenommen (4, 5), und ein zweites, den Echos dieser Signale entsprechendes Bild ($I_2$) wird berechnet (6), indem jedem Bildpunkt ein Wert zugewiesen wird, welcher dem Signal der magnetischen Resonanz des Punktes entspricht, der ihm in dem Körper entspricht;

– die zugewiesenen Werte für das erste Bild werden Punkt für Punkt mit den zugewiesenen Werten für das zweite Bild verglichen (7), um ein drittes Bild ($I_3$) zu erzeugen, welches für die molekulare Streuung in jedem Punkt des Körpers repräsentativ ist.

2. Verfahren nach Anspruch 1, dadurch gekennzeichnet, daß die zweiten Sequenzen längere und/oder stärkere Impulse (41–48) der Feldgradienten in Abwesenheit der Spinecho-Anregungen umfassen, wobei diese Feldgradienten entlang einer Achse orientiert sind, um Feldgradienten-Beiträge zu bilden.

3. Verfahren nach Anspruch 2, in welchem die Feldgradient-Sequenzen Impulse des entlang drei Achsen (X, Y, Z) orientierten Feldgradienten umfassen: die Achse (Z) des konstanten Feldes ($B_0$), als Selektionsachse bezeichnet, und zwei Achsen (X, Y), welche zu dieser Achse orthogonal sind und als Phasenkodierachse (Y) bzw. als Ableseachse (X) bezeichnet werden, in welchem die Methode zur Berechnung der Bilder vom Typ 2DFT ist, dadurch gekennzeichnet, daß die Achse der Beiträge die Leseachse ist.

4. Verfahren nach Anspruch 2, in welchem die Feldgradient-Sequenzen Impulse des entlang drei Achsen (X, Y, Z) orientierten Feldgradienten umfassen: die Achse (Z) des konstanten Feldes ($B_0$), als Selektionsachse bezeichnet, sowie zwei Achsen (X, Y), welche zu dieser Achse orthogonal sind und als Phasenkodierachse (Y) bzw. als Ableseachse (X) bezeichnet werden, in welchem die Methode zur Berechnung der Bilder vom Typ 2DFT ist, dadurch gekennzeichnet, daß die Achse der Beiträge die Selektionsachse ist.

5. Verfahren nach Anspruch 2, in welchem die Feldgradient-Sequenzen Impulse des entlang drei Achsen (X, Y, Z) orientierten Feldgradienten umfassen: die Achse (Z) des konstanten Feldes ($B_0$), als Selektionsachse bezeichnet, sowie zwei Achsen (X, Y), welche zu dieser Achse orthogonal sind und als Phasenkodierachse (Y) bzw. als Ableseachse (X) bezeichnet werden, in welchem die Methode zur Berechnung der Bilder vom Typ 2DFT ist, dadurch gekennzeichnet, daß die Achse der Beiträge die Phasenkodierachse ist.

6. Verfahren nach einem der Ansprüche 1 bis 5, dadurch gekennzeichnet, daß es mehrmals angewandt wird, um dritte Mehrschnittsbilder des beobachteten Körpers zu erzeugen.

7. Verfahren nach einem der Ansprüche 2 bis 6, dadurch gekennzeichnet, daß die Zeitpunkte der Anwendung der Gradienten-Beiträge von den funkfrequenten 180°-Anregungen zeitlich so weit wie möglich entfernt sind.

8. Verfahren nach einem der Ansprüche 1 bis 7, dadurch gekennzeichnet, daß ein Eichkörper (33) neben dem Körper angeordnet wird, um die Berechnungen des dritten Bildes zu eichen.

9. Verfahren nach einem der Ansprüche 1 bis 8, dadurch gekennzeichnet, daß alle Dauern der Echozeit ($T_E'$) der ersten Spinecho-Sequenzen miteinander gleich sind.

10. Verfahren nach einem der Ansprüche 1 bis 9, dadurch gekennzeichnet, daß N 4 entspricht.

11. Verfahren nach Anspruch 2, dadurch gekennzeichnet, daß die das zweite Bild betreffenden Schritte mit Gradient-Beiträgen, welche entlang einer anderen Achse orientiert sind, wiederholt werden, damit ein weiteres drittes Bild erzeugt wird, um das Wesen der abgebildeten Bereiche zu bestimmen.

12. Verfahren nach einem der Ansprüche 1 bis 11, dadurch gekennzeichnet, daß man den Logarithmus des Verhältnisses zwischen den Werten für den Vergleich Punkt für Punkt berechnet.

13. Verfahren nach einem der Ansprüche 1 bis 12, 21 oder 22, dadurch gekennzeichnet, daß der Effekt der Geschwindigkeit (V) der beweglichen Teile des Körpers, der durch die Feldgradient-Sequenzen, welche als Stör-Sequenzen bezeichnet werden, verursacht wird, moduliert wird, indem vor dem Aufnehmen ($t_{E1}$) einer Sequenz (310–430) ein Kompensations-Magnetfeld angelegt wird, dessen über seine Dauer berechnetes Integral gleich null ist und dessen Evolution sowie dessen Wert von der Evolution und von dem Wert der Störfelder abhängig sind.

14. Verfahren nach Anspruch 13, dadurch gekennzeichnet, daß die Sequenz des Stör-Magnetfeldes Magnetfeld-Impulse entlang drei zueinander orthogonalen Achsen (X, Y, Z) umfaßt und daß die Sequenz des Kompensations-Magnetfeldes Magnetfeld-Impulse entlang diesen drei selben Achsen umfaßt, um die Effekte der Geschwindigkeit der beweglichen Teile des Körpers entlang diesen drei selben Achsen einzeln zu modulieren.

15. Verfahren nach Anspruch 14, dadurch gekennzeichnet, daß die Form, die Dauer und die Position der Impulse des Kompensations-Magnetfeldes im voraus bestimmt sind und daß deren Amplitude berechnet wird, um die gesuchte Modulation zu erhalten.

16. Verfahren nach Anspruch 13 oder 14 oder 15, dadurch gekennzeichnet, daß die Sequenz der Kompensations-Magnetfelder bipolare Impulspaare umfaßt.

17. Verfahren nach einem der Ansprüche 13 bis 16, dadurch gekennzeichnet, daß die Sequenz der Kompensations-Magnetfelder Impulspaare umfaßt, wobei jeder Impuls eines Paares denselben Wert, dieselbe Form, dieselbe Dauer und dasselbe Vorzeichen wie der andere Impuls des Paares aufweist, und diese Impulse jeweils vor und nach einer zweiten funkfrequenten Anregung erfolgen.

18. Verfahren nach einem der Ansprüche 13 bis 17, dadurch gekennzeichnet, daß die Integrale des Produkts aus dem Wert der Störfeld-Impulse und der Dauer, welche sie von der Aufnahme des ausgesendeten Signals trennt, durch die Integrale eines gleichen Produkts kompensiert wird, welches mit den Kompensationsfeld-Impulsen erhalten wird.

19. Verfahren nach Anspruch 16 oder 17, dadurch gekennzeichnet, daß die Impulse der Impulspaare Impulse umfassen, welche voneinander möglichst weit entfernt sind.

20. Verfahren nach einem der Ansprüche 13 bis 19, dadurch gekennzeichnet, daß der Effekt der Geschwindigkeit der beweglichen Teile des Körpers, welcher nur durch die zweiten Feldgradient-Sequenzen bewirkt wird, moduliert wird.

21. Verfahren nach Anspruch 1, dadurch gekennzeichnet, daß:
– der so angeordnete Körper einer dritten Vielzahl von dritten Spinecho-Anregungssequenzen in Anwesenheit von dritten Feldgradient-Sequenzen ausgesetzt wird; wobei die dritten Spinecho-Sequenzen wenigstens eine Anregung bei 180° nach der Anregung bei 90° umfassen, um streuende Sequenzen mit wenigstens einem Echo zu erzeugen; wobei die gesamte Echodauer der dritten Anregungssequenzen der gesamten Echodauer der ersten Anregungssequenzen entspricht und die dritten Feldgradient-Sequenzen sich von den zweiten Feldgradient-Sequenzen unterscheiden;
– die Signale der magnetischen Resonanz am Ende dieser dritten Anregungssequenzen aufgenommen werden und ein viertes Bild, welches den Echos dieser Signale entspricht, berechnet wird, indem jedem Bildpunkt ein Wert zugewiesen wird, der dem Signal der magnetischen Resonanz des Punktes entspricht, der ihm in dem Körper entspricht;
– die zugewiesenen Werte für das dritte Bild werden Punkt für Punkt mit den zugewiesenen Werten für das vierte Bild verglichen, um ein fünftes Bild zu erzeugen, welches für die molekulare Streuung in jedem Punkt des Körpers repräsentativ ist;
– die zugewiesenen Werte für das dritte Bild werden Punkt für Punkt mit den zugewiesenen Werten für das fünfte Bild verglichen, um ein sechstes Bild, welches für die echte molekulare Streuung in dem Körper repräsentativ und von störenden Mikroströmungen frei ist, zu erzeugen.

22. Verfahren nach Anspruch 1, dadurch gekennzeichnet, daß:
– der so angeordnete Körper einer dritten Vielzahl von dritten Spinecho-Anregungssequenzen in Anwesenheit von dritten Feldgradient-Sequenzen ausgesetzt wird; wobei die dritten Spinecho-Sequenzen wenigstens eine Anregung bei 180° nach der Anregung bei 90° umfassen, um streuende Sequenzen mit wenigstens einem Echo zu bilden; wobei die gesamte Echodauer der dritten Anregungssequenzen der gesamten Echodauer der ersten Anregungssequenzen entspricht und die dritten Feldgradient-Sequenzen sich von den zweiten Feldgradient-Sequenzen unterscheiden;
– die Signale der magnetischen Resonanz am Ende dieser dritten Anregungssequenzen aufgenommen werden und ein viertes Bild, welches den Echos dieser Signale entspricht, berechnet wird, indem jedem Punkt des Bildes ein Wert zugewiesen wird, welcher dem Signal der magnetischen Resonanz des Punktes entspricht, der ihm in dem Körper entspricht;
– die zugewiesenen Werte für das erste Bild werden Punkt für Punkt mit den zugewiesenen Werten für das vierte Bild verglichen, um ein fünftes Bild, welches für die molekulare Streuung in jedem Punkt des Körpers repräsentativ ist, zu erzeugen;
– die zugewiesen Werte für das dritte Bild werden Punkt für Punkt mit den zugewiesenen Werten für das fünfte Bild verglichen, um ein siebtes Bild, welches für ein Durchsetzungs-Phänomen in dem Körper repräsentativ ist, zu erzeugen.

23. Verfahren nach Anspruch 21 und 22, dadurch gekennzeichnet, daß das sechste Bild sowie das siebte Bild gleichzeitig erzeugt werden.

24. Verfahren nach einem der Ansprüche 1 bis 23, dadurch gekennzeichnet, daß die streuenden Sequenzen Sequenzen mit einem einzigen Spinecho sind.

## Claims

1. A method of forming an image using nuclear magnetic resonance (1–9 and 50) comprising the following stages for producing and image ($I_3$) of the molecular diffusion of a body under examination:
– placing the body (2) in a constant magnetic field ($B_0$);
– submitting (3–4 and $C_1$) the body so placed to a first plurality of first spin echo sequences of excitations in the presence of first field gradient sequences; said spin echo sequences comprising a whole number N, greater than or equal to 1, of excitations (16 to 19) where the magnetic moments of the nuclei are swung through 180° after an excitation (15) where these moments have been swung through 90° in order to thus create sequences with N echoes which are low in diffusion;

– detecting (4 and 5) the magnetic resonance signals at the end of these first sequences of excitations and calculation (6) of a first image (1) corresponding to the echoes N of these signals while attributing to each point of the image a value ($S_N$) corresponding to the signal of magnetic resonance of the point which corresponds to it in the body;

– submitting (3–4 and $C_2$) the body so placed to a second plurality of second echo spin excitations in the presence of second field gradient sequences; these second echo spin sequences comprising at least one excitation at 180° (26) after the excitation at 90° (15) in order to create diffusing sequences with at least one echo; the total echo duration (TE) of the second sequences of excitations being equal to the total echo duration (N•TE) of the first sequences of excitations;

– detecting (4 and 5) the magnetic resonance signals at the end of these second excitation sequences and calculating (6) a second image ($I_2$) corresponding to the echoes of these signals while attributing to each image point a value corresponding to the magnetic resonance signal of the point which corresponds to it in the body;

– comparison (7) point by point of the values attributed for the first image with the values attributed for the second image in order to produce a third image ($I_3$) representative of the molecular diffusion at each point of the body.

2. The method as claimed in claim 1, characterized in that the second sequences comprise field gradient pulses (41 to 48) which are longer and/or are stronger when not in the presence of spin echo excitations and orientated in accordance with an axis in order to constitute field gradient supplements.

3. The method as claimed in claim 2, in which the field gradient sequences comprise field gradient pulses orientated in accordance with three axes (X, Y and Z): the axis (Z) of the constant field ($B_0$), or the selection axis, and two axes (Z and Y) at a right angle to this axis referred to respectively as the phase encoding axis (Y) and the reading axis (X), in which the method of calculation of the images is of the 2DFT type, characterized in that the axis of supplements is the axis of reading.

4. The method as claimed in claim 2, in which the field gradient sequences comprise field gradient pulses orientated in accordance with three axes (X, Y and Z): the constant field ($B_0$) axis (Z), or axis of selection, and two axes (X and Y) at a right angle to this axis termed respectively the phase encoding axis (Y) and the reading axis (X), in which the method of calculation is of the images of the 2DFT type, characterized in that the axis of supplements is the selection axis.

5. The method as claimed in claim 2, in which the field gradient sequences comprise field gradient pulses orientated in accordance with three axes (X, Y and Z): the constant field ($B_0$) axis (Z), or axis of selection, and two axes (X and Y) at a right angle to this axis termed respectively the phase encoding axis (Y) and the reading axis (X), in which the method of calculation is of the images of the 2DFT type, characterized in that the axis of supplements is the phase encoding axis.

6. The method as claimed in any one of the claims 1 through 5, characterized in that it is performed a number of times in order to create third multicut angles of the body under examination.

7. The method as claimed in any one of the claims 2 through 6, characterized in that the instants of application of the gradient supplements are as far removed as possible at the time of radio frequency excitation at 180°.

8. The method as claimed in any one of the claims 1 through 7, characterized in that a sample body (33) is placed alongside said body for calibration for calculation of the third image.

9. The method as claimed in any one of the claims 1 through 8, characterized in that the durations of the echo times (TE) of the first spin echo sequences are all equal to each other.

10. The method as claimed in any one of the claims 1 through 9, characterized in that the N is equal to 4.

11. The method as claimed in claim 2, characterized in that the steps relating to the second image are reiterated with gradient supplements orientated in accordance with another axis in order to create another third image in order to determine the nature of the regions of which an image is produced.

12. The method as claimed in any one of the claims 1 through 11, characterized in that for the point by point comparison the logarithm of the ratio of the said values is calculated.

13. The method as claimed in any one of the claims 1 through 12, in claim 21 or in claim 22, characterized in that the effect of the speed (V) of the moving parts of the body created by field gradient sequences, termed disturbance due to application, before the detection ($t_{E1}$), of a sequence (310 to 430) of a compensating magnetic field is modulated, whose integral with respect to duration is zero, and of which the history and the value are a function of the history and the value of the disturbing fields.

14. The method as claimed in claim 13, characterized in that the sequence of the disturbing magnetic field comprises magnetic field pulses in accordance with three orthogonal axes (X, Y and Z), and in that the sequence of the compensating magnetic field comprises magnetic field pulses in accordance with these three same axes, in order to modulate the effects of the speed of the moving parts of the body in accordance with these three same axes.

15. The method as claimed in claim 14, characterized in that the compensating magnetic field pulses are determined a priori in form, in duration and in position and in that their amplitude is evaluated in order to obtain the required modulation.

16. The method as claimed in claim 13, claim 14 or claim 15, characterized in that the compensating magnetic field sequence comprises bipolar pairs of pulses.

17. The method as claimed in any one of the claims 13 through 16, characterized in that the sequence of compensating magnetic fields comprises pairs of pulses, each pulse of a pair being with respect to value, form, duration and sign identical to the other pulse of the pair, and these pulses are located respectively prior to and after a second radio frequency excitation.

18. The method as claimed in any one of the claims 13 through 17, characterized in that the integral of the production of the value of the disturbing field pulses and of the duration which separates them from the detection of the emitted signal is compensated by the integral of an identical product obtained with compensating field pulses.

19. The method as claimed in claim 16 or claim 17, characterized in that the pulses of the pairs of pulses comprise pulses which are removed as far as possible from each other.

20. The method as claimed in any one of the claims 13 through 19, characterized by modulation of the effect of the speed of the moving parts of the body created only by the second field gradient sequences.

21. The method as claimed in claim 1, characterized in that:
– the body so placed is subjected to a third plurality of third spin echo sequences of excitation in the presence of a third field gradient; the third spin echo sequences comprise at least one excitation at 180° after the excitation at 90° in order to create diffusing sequences with at least one echo; the total duration of the third sequences of excitation being equal to the total duration of the echo of the first sequences of excitation; the third field gradient sequences being different from the second field gradient sequences;
– the magnetic resonance signals are detected at the end of these third excitation sequences and a fourth image is calculated corresponding to the echoes of these signals while attributing to each point of the image a value corresponding to the magnetic resonance signal which corresponds to it in the body;
– the values attributed for the first image are compared point by point with the values attributed for the fourth image in order to create a fifth image representative of the molecular fusion at each point of the body;
– the values attributed for the third image are compared point by point with the values attributed for the fifth image in order to create a sixth image representative of the true molecular diffusion in the body and free of micro-circulation parasitic effects.

22. The method as claimed in claim 1, characterized in that:
– the body so placed is subjected to a third plurality of third spin echo sequences of excitation in the presence of third field gradient sequences; the third spin echo sequences comprise at least one excitation at 180° after the excitation at 90° in order to create diffusing sequences with at least one echo; the total duration of the third sequences of excitation being equal to the total duration of the echo of the first sequences of excitation; the third field gradient sequences being different from the second field gradient sequences;
– the magnetic resonance signals are detected at the end of these third excitation sequences and a fourth image is calculated corresponding to the echoes of these signals while attributing to each point of the image a value corresponding to the magnetic resonance signal which corresponds to it in the body;
– the values attributed for the first image are compared point by point with the values attributed for the fourth image in order to create a fifth image representative of the molecular fusion at each point of the body;
– the values attributed for the third image are compared point by point with the values attributed for the fifth image in order to create a seventh image representative of perfusion phenomena in the body.

23. The method as claimed in claim 21 and claim 22, characterized in that the sixth and the seventh images are simultaneously created.

24. The method as claimed in any one of the claims 1 through 23, characterized in that the diffusing sequences are single spin echo sequences.

FIG_1

# FIG_2-a

$T_E'/2$

$T_E'/2$

Z

X

Y

RF

11

12

41

42

43

48

$T_E'$

$T_E = N.T_E'$

EP 0 208 601 B1

# FIG_2-b

# FIG_2-c

FIG. 3-a

FIG. 3-b

FIG. 4

EP 0 208 601 B1

# FIG. 5

EP 0 208 601 B1

FIG_7

FIG. 6-a

FIG. 6-b